# EUROPEAN PATENT SPECIFICATION

(11) **EP 2 877 729 B1**
(45) Date of publication and mention of the grant of the patent: **27.07.2016**
(21) Application number: 13730370.7
(22) Date of filing: 31.05.2013
(51) Int. Cl.: F02D 41/00, G01R 31/36

(54) **ENGINE CONTROL DEVICE AND VEHICLE INCLUDING THE SAME**
MOTORSTEUERUNGSVORRICHTUNG UND FAHRZEUG DAMIT
DISPOSITIF DE COMMANDE DE MOTEUR ET VÉHICULE LE COMPRENANT

(30) Priority: 09.07.2012 JP 2012153927
(43) Date of publication of application: 03.06.2015
(73) Proprietor: Yamaha Hatsudoki Kabushiki Kaisha, Iwata-shi, Shizuoka 438-8501 (JP)
(72) Inventor: MAEBASHI, Kosei, Iwata-shi Shizuoka 438-8501 (JP)
(74) Representative: Zimmermann, Tankred Klaus
(86) International application number: PCT/JP2013/003447
(87) International publication number: WO 2014/010163

(56) References cited:
- EP-A1- 1 686 391
- DE-A1- 10 243 567
- JP-A- 2009 255 742
- US-A1- 2009 020 092

## Description

### Technical Field

The present invention relates to a control device that controls an engine to be started by a starter motor that is driven by electric power supplied from a battery, and a vehicle including such a control device.

### Background Art

Patent Document 1 discloses a battery state judgment device that judges deterioration of a battery that supplies electric power to a starter for starting an engine. In detail, an ECU (electronic control unit) for controlling the operation of the engine monitors a battery voltage when the starter is actuated, and judges that the battery has deteriorated when the battery voltage decreases to a predetermined threshold or less.

### Citation List

### Patent Literature

PTL 1: Japanese Unexamined Patent Application Publication No. 2009-255742

### Summary of Invention

### Solution to Problem

The prior art described in Patent Literature 1 judges deterioration of a battery by comparing a battery voltage with a predetermined threshold. However, even if the battery voltage does not drop to the threshold, when a cranking load is high, sufficient rotation of the crankshaft cannot be caused, and it may become difficult to start the engine. The causes of an increase in cranking load are an increase in rotation resistance due to aging change of the gears, an increase in viscosity of the lubricant at a cool temperature, etc. Therefore, if the battery voltage is merely compared with a predetermined threshold, a state where the battery has deteriorated so that it cannot start the engine may not be judged accurately. This problem may be solved by setting the threshold to a high value. However, if the threshold is set to a high value, it may be judged that the battery has deteriorated although the battery still has enough power. Therefore, the battery deterioration state cannot be judged accurately.

A preferred embodiment of the present invention provides an engine control device that controls an engine including a starter motor to be driven by electric power supplied from a battery and a crankshaft. The engine control device includes an angular velocity-equivalent information acquiring means that acquires information equivalent to an angular velocity of the crankshaft before starting of the engine is completed when starting the engine by actuating the starter motor, and a battery deterioration judging means that judges that the battery has deteriorated when information acquired by the angular velocity-equivalent information acquiring means is equivalent to an angular velocity of a predetermined value or less.

With this configuration, when the starter motor is actuated, information equivalent to an angular velocity of the crankshaft is acquired before starting of the engine is completed. The more the battery deteriorates and the higher the cranking load, the smaller the angular velocity of the crankshaft. Specifically, if the angular velocity of the crankshaft when the engine starts is small, there is a possibility that a battery output necessary for starting the engine by sufficiently rotating the crankshaft against the cranking load has not been secured. If the angular velocity of the crankshaft when the engine starts is sufficiently large, it is considered that a battery output sufficient for starting the engine has been secured even if the battery voltage slightly decreases. Therefore, in the present preferred embodiment, when information showing that the angular velocity of the crankshaft at the time of start is a predetermined value or less is acquired, it is judged that the battery has deteriorated. Accordingly, unlike the case where the battery voltage is compared with a predetermined threshold, deterioration of the battery can be properly judged from the point of view of whether starting of the engine is possible in consideration of the magnitude of the cranking load.

In a preferred embodiment of the present invention, the angular velocity-equivalent information acquiring means acquires information equivalent to an angular velocity of the crankshaft when the rotation position of the crankshaft is just before a compression top dead point position. With this configuration, information equivalent to an angular velocity of the crankshaft is acquired just before a compression top dead point position, so that deterioration of the battery can be more properly judged. Specifically, when the rotation position of the crankshaft is just before the compression top dead point position, the load (cranking load) necessary for rotating the crankshaft becomes maximum. Therefore, by using information equivalent to an angular velocity of the crankshaft just before the compression top dead point position, it can be more properly judged whether the battery starts the engine while having enough power to spare.

The cranking load becomes maximum just before the compression top dead point position, so that when the engine is stopped, at a high degree of probability, the crankshaft stops at a rotation position just before the compression top dead point. Therefore, the first top dead point position after the engine starts is the compression top dead point position in most cases. Therefore, by acquiring information equivalent to an angular velocity of the crankshaft just before the first top dead point position after the engine starts, at a high degree of probability, information equivalent to an angular velocity of the crankshaft just before the compression top dead point position can be acquired.

"Rotation position just before the compression top dead point position" may be a position within a rotation position range of 180 degrees or less just before the compression top dead point position. Specifically, in a four-stroke engine in which one cycle consists of four strokes of intake, compression, explosion, and exhaust, the rotation position is a rotation position of the crankshaft corresponding to a compression stroke. More preferably, the "rotation position just before the compression top dead point position" may be a rotation position of 90 degrees or less just before the compression top dead point position, that is, a rotation position of the crankshaft in a latter half of the compression stroke.

In a preferred embodiment of the present invention, the engine includes an ignition plug that causes spark discharge inside a combustion chamber and an ignition coil that stores energy to be supplied to the ignition plug, the engine control device includes an ignition control section that energizes the ignition coil when the rotation position of the crankshaft reaches an energization start position, and stops energization of the ignition coil and makes the ignition plug cause spark discharge when the rotation position of the crankshaft reaches an ignition position, and the angular velocity-equivalent information acquiring means measures an energization time of the ignition coil.

With this configuration, when the crankshaft reaches the energization start position, energization of the ignition coil is started, and when the crankshaft reaches the ignition position, energization of the ignition coil is stopped. Therefore, the energization time of the ignition coil is equal to a rotation time from the energization start position to the ignition position of the crankshaft, and is in inverse proportion to the angular velocity of the crankshaft. Therefore, in the present preferred embodiment, the energization time of the ignition coil is measured, and by using the measured energization time (ignition coil energization time) as an index that indicates an angular velocity (information equivalent to the angular velocity), it is judged whether the battery has deteriorated. In detail, the angular velocity not more than a predetermined value of the crankshaft is equivalent to the ignition coil energization time not less than a threshold corresponding to the predetermined value. Therefore, by comparing the ignition coil energization time with the threshold, deterioration of the battery can be judged.

The rotation angle range of the crankshaft from the energization start position to the ignition position may be positioned just before the top dead point position. In this case, by measuring the energization time of the ignition coil, the measured energization time corresponds to the angular velocity of the crankshaft just before the top dead point position. Accordingly, judgment on deterioration of the battery can be more properly made.

The engine control device according to a preferred embodiment of the present invention further includes a rotary member that rotates together with the crankshaft, and has a plurality of detection bodies disposed at even intervals along a rotation direction of the crankshaft, a detection means that has a detection region at a fixed position on a path that the detection bodies pass through according to rotation of the rotary member, and detects passages of the detection bodies through the detection region, and a detection body identifying means that identifies an energization start detection body that provides a timing to start energization of the ignition coil and an ignition detection body that provides a timing of ignition of the ignition plug among the plurality of detection bodies based on an output of the detection means. In this case, the ignition control section preferably starts energization of the ignition coil in response to identification of the energization start detection body, and stops energization of the ignition coil in response to identification of the ignition detection body.

With this configuration, when the crankshaft rotates, according to the rotation, the rotary member rotates, and the plurality of detection bodies disposed at even intervals along the rotation direction of the rotary member pass through the detection region of the detection means in order. The detection means outputs signals corresponding to passages of the detection bodies. The detection bodies are disposed at even intervals, so that the output of the detection body periodically changes according to the angular velocity of the crankshaft. On the other hand, the plurality of detection bodies include an energization start detection body and an ignition detection body, and are identified by the detection body identifying means. When the energization start detection body is detected, energization of the ignition coil is started, and when the ignition detection body is detected, energization of the ignition coil is stopped and the ignition plug causes spark discharge. Therefore, the energization time of the ignition coil corresponds to the angular velocity of the crankshaft.

The angular velocity-equivalent information acquiring means may measure an energization time of the ignition coil by measuring a time from identification of the energization start detection body to identification of the ignition detection body, a time during which the ignition control section issues an energization command, or a time during which an electric current is supplied to the ignition coil.

In a preferred embodiment of the present invention, the engine control device further includes a stroke identifying means that identifies the stroke of the engine, and the angular velocity-equivalent information acquiring means measures an energization time of the ignition coil in a compression stroke based on results of stroke identification performed by the stroke identifying means. With this configuration, the stroke of the engine can be identified by the stroke identifying means. Then, based on the identification results, in a compression stroke, an energization time of the ignition coil is measured. Accordingly, the energization time of the ignition coil corresponds to the angular velocity of the crankshaft in the compression stroke with a high cranking load. Therefore, based on the energization time of the ignition coil in the compression stroke, deterioration of the battery can be properly judged.

In a preferred embodiment of the present invention, the rotary member further includes a first reference position detection portion that provides a first reference rotation position of the crankshaft, and a second reference position detection portion that provides a second reference rotation position different from the first reference rotation position, and the first reference position detection portion and the second reference position detection portion are provided on the rotary member so as to pass through the detection region of the detection means, and are configured to be distinguished from each other based on an output of the detection means, and the detection body identifying means identifies the energization start detection body and the ignition detection body by using, as a reference, either one detected earlier of the first reference position detection portion and the second reference position detection portion after driving of the starter motor is started.

With this configuration, the first reference position detection portion and the second reference position detection portion are provided, so that by using either one of these as a reference, the energization start detection body and the ignition detection body can be identified. Therefore, as compared with the case where only one reference position detection portion is provided, the possibility of quicker identification of the energization start detection body increases, so that the possibility of reduction in time from start of the starter motor to start of energization of the ignition coil increases. Accordingly, after the starter motor is started, an energization time of the ignition coil when the angular velocity of the crankshaft is not so high can be measured, so that judgment on deterioration of the battery can be more properly made.

The second reference position detection portion is preferably disposed between the energization start detection body and the detection body that is detected just before the energization start detection body by the detection means. With this configuration, the second reference position detection portion is detected by the detection means just before the energization start detection body passes through the detection region of the detection means, and accordingly, a reference position of the rotation position of the crankshaft is provided. Accordingly, the possibility of starting energization of the ignition coil when the energization start detection body passes through the detection region of the detection means for the first time after the starter motor is started increases. Therefore, after the starter motor is started, the energization time of the ignition coil can be measured before the angular velocity of the crankshaft becomes high, so that based on the measured energization time, judgment on deterioration of the battery can be more properly made.

The engine control device according to a preferred embodiment of the present invention further includes an idling-stop control section that switches the engine into an idling-stop state when a predetermined idling-stop condition is satisfied during an idling state of the engine, and an engine restart control section that restarts the engine when a predetermined restart condition is satisfied during the idling-stop state. In this case, the idling-stop condition preferably includes a condition that the battery deterioration judging means does not judge that the battery has deteriorated.

With this configuration, a battery deterioration state is properly judged based on information equivalent to an angular velocity of the crankshaft when cranking, and based on the properly judged battery deterioration state, it is judged whether the engine should be switched into an idling-stop state. Therefore, when the battery deteriorates, the engine is not switched into an idling-stop state. In other words, when the engine is switched into an idling-stop state, the battery has not deteriorated. Therefore, when the restart condition is satisfied during an idling-stop state, the engine can be reliably restarted. If the battery output is sufficient against a cranking load, the engine can be switched into an idling-stop state, so that the battery is not wastefully depleted. Accordingly, energy-saving performance can be improved.

A preferred embodiment of the present invention provides a vehicle that includes an engine control device having the above-described features and an engine to be controlled by the engine control device, and uses the engine as a power source.

Other elements, features, steps, characteristics and advantages of the present invention will more apparent from the following detailed description of the preferred embodiments with reference to the attached drawings.

### Brief Description of Drawings

[fig.1]Fig. 1 is an illustrative side view for describing a configuration of a motorcycle which is an example of a saddle type vehicle to which an engine control device according to a preferred embodiment of the present invention is applied.
[fig.2]Fig. 2 is a perspective view showing a configuration example of a handle of the motorcycle.
[fig.3]Fig. 3 is a horizontal sectional view of a power unit of the motorcycle.
[fig.4]Fig. 4 is a schematic view for describing a configuration relating to an engine installed in the power unit.
[fig.5]Fig. 5 is a schematic view for describing a configuration for detecting a rotation position or a crank angle of the crankshaft of the engine.
[fig.6]Fig. 6 is a block diagram for describing an electrical configuration relating to control of the engine.
[fig.7]Fig. 7 is a block diagram for describing a functional configuration of an ECU (Electronic Control Unit) that controls the engine.
[fig.8]Fig. 8 is a flowchart for describing a flow from start of the engine to switching into an idling-stop state.
[fig.9]Fig. 9 is a flowchart for describing the details of engine start control.
[fig.10]Fig. 10 is a flowchart for describing a detailed example of judgment on deterioration of the battery.
(fig.11]Fig. 11 is a waveform chart showing waveform examples of crank pulses and an ignition signal when the engine starts.
[fig.12]Fig. 12 is a flowchart for describing a detailed example of judgment (Step S5 in Fig. 8) of idling-stop conditions.
[fig.13]Fig. 13 is a flowchart for describing an example of control for restarting the engine in an idling-stop state.
[fig.14]Fig. 14 is a block diagram for describing a configuration of an engine control device according to another preferred embodiment of the present invention.
[fig.15]Fig. 15 is a waveform chart showing waveform examples of a stroke identification signal, crank pulses, and an ignition signal when the engine starts in the preferred embodiment in FIG. 14.

### Description of Embodiments

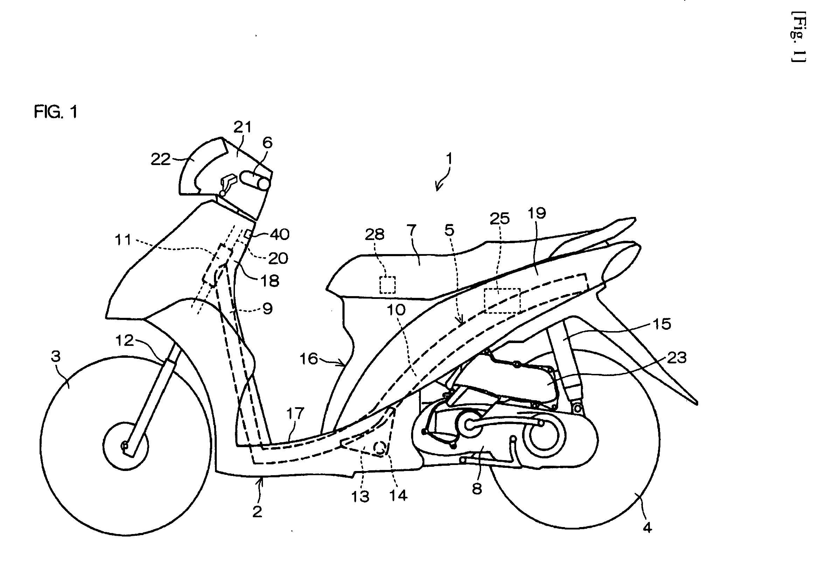

Fig. 1 is a side view for describing a configuration of a saddle type vehicle to which an engine control device according to a preferred embodiment of the present invention is applied. Fig. 1 shows a scooter type motorcycle 1 as an example of a saddle type vehicle. In the following description, for convenience, based on the point of view of a rider (driver) getting on the motorcycle 1, the front-rear, left-right, and up-down directions of the motorcycle 1 are defined.

A motorcycle 1 includes a vehicle main body 2, a front wheel 3, and a rear wheel 4. The vehicle main body 2 includes a vehicle body frame 5, a handle 6, a seat 7, and a power unit 8. The vehicle body frame 5 includes a down tube 9 disposed on the front side, and a pair of left and right side frames 10 disposed at the rear of the down tube 9. The down tube 9 extends forward to the diagonally upper side, and to an upper end portion thereof, a head pipe 11 is fixed. On this head pipe 11, a steering shaft 20 is supported turnably. To the lower end of the steering shaft 20, a pair of left and right front forks 12 are fixed. To an upper end portion of the steering shaft 20, the handle 6 is attached, and to the lower end portions of the front forks 12, a front wheel 3 is attached rotatably. The side frames 10 are curved in substantially S shapes, and extend rearward to the diagonally upper side from the lower end of the down tube 9. On the side frames 10, a seat 7 is supported. To the vicinities of the intermediate portions of the side frames 10, a bracket 13 is fixed. On the bracket 13, the power unit 8 is supported so as to swing up and down via a pivot shaft 14. The power unit 8 is a unit swing type engine unit. Above the power unit 8, an air cleaner 23 for cleaning the air to be taken into the engine is disposed. Cushion units 15 are laid between the vicinities of the rear end portions of the side frames 10 and the rear end portion of the power unit 8. On the rear end portion of the power unit 8, a rear wheel 4 is supported rotatably.

The vehicle body frame 5 is covered by a vehicle body cover 16 made of resin. The vehicle body cover 16 includes a foot board 17 that is provided below the front side of the seat 7 and provides a foot placing portion, a front cover 18 that covers the head pipe 11, a side cover 19 that covers the region below the seat 7, and a handle cover 21 that covers the handle 6. A battery 25 is housed in a space covered by the side cover 19 below the seat 7, and is supported on the vehicle body frame 5. A headlight 22 is provided to be exposed forward from the handle cover 21, and supported on the handle 6. A main switch 40 for supplying electric power charged in the battery 25 to the motorcycle 1 is disposed on, for example, the rear surface (surface facing the seat 7) of the front cover 18. The main switch 40 may be a key switch that is operated by using a key held by a user.

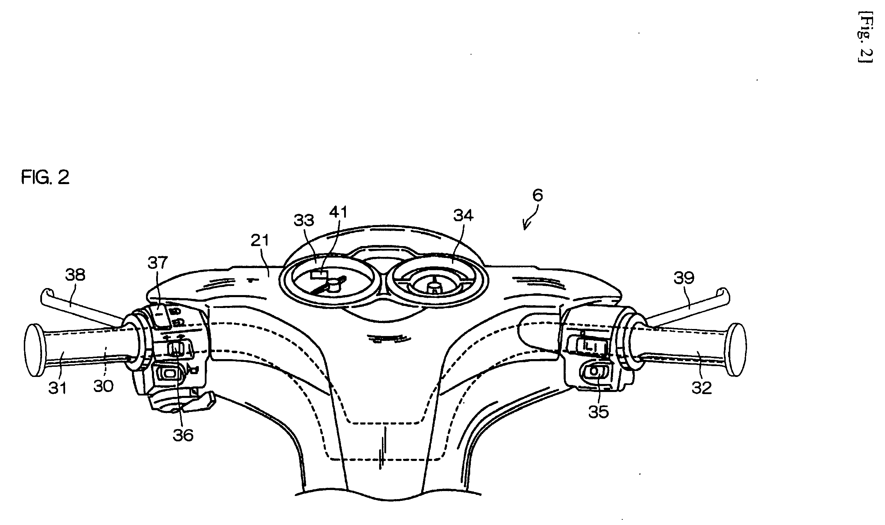

Fig. 2 is a perspective view showing a configuration example of the handle 6, and shows a configuration viewed down from a driver seated on the seat 7. The handle 6 includes a handle bar 30 extending in the left-right direction, and grips 31 and 32 provided on the left end and right end of the handle bar 30. Ahead of the left grip 31, a rear wheel brake lever 38 for actuating a rear wheel brake is disposed, and ahead of the right grip 32, a front wheel brake lever 39 for actuating a front wheel brake is disposed. The right grip 32 is attached turnably in a predetermined angle range around the axis of the handle bar 30, and is an accelerator grip for an accelerating operation. The handle bar 30 is covered by the handle cover 21. The handle cover 21 is provided with a speed meter 33 and an engine rotation speed meter 34. On the speed meter 33, an indicator 41 is disposed. The indicator 41 is turned on when the engine is switched into an idling-stop state by idling-stop control described later. Near the accelerator grip 32, a starter button 35 for starting the engine is disposed. Near the left grip 31, a turn signal switch 36, a headlight switch 37, etc., are disposed.

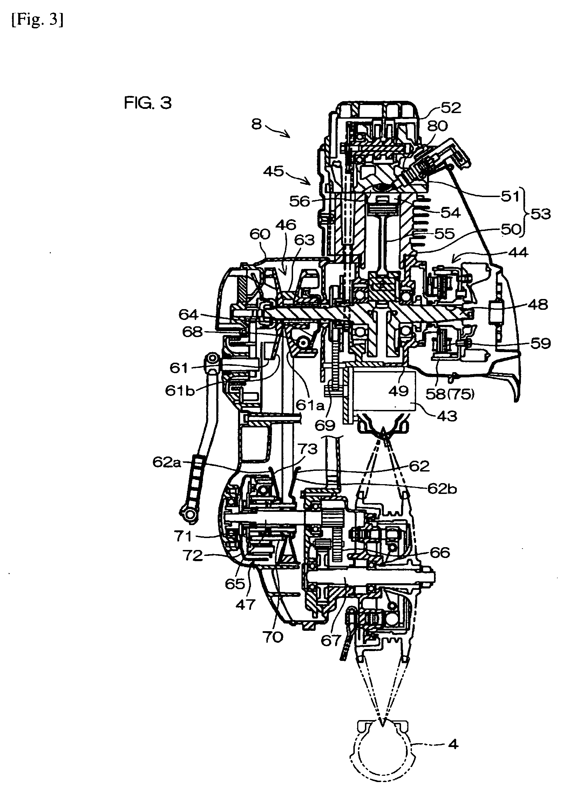

Fig. 3 is a horizontal sectional view of the power unit 8, and shows a section viewed from above, and the upper side corresponds to the front side of the motorcycle 1, and the lower side corresponds to the rear side of the motorcycle 1. The power unit 8 includes a starter motor 43, a power generator 44, an engine 45, a V-belt type continuously variable transmission 46, and a centrifugal clutch 47. The engine 45 is a four-stroke gasoline engine in this embodiment.

The engine 45 includes a crankshaft 48 extending in the left-right direction, a crankcase 49 that houses the crankshaft 48, a cylinder block 50 extending forward from the crankcase 49, a cylinder head 51 fixed to the tip end portion of the cylinder block 50, and a head cover 52 fixed to the tip end portion of the cylinder head 51. The cylinder block 50 and the cylinder head 51 constitute a cylinder 53. Inside the cylinder block 50, a piston 54 is housed slidably. The piston 54 and the crankshaft 48 are joined by a connection rod 55. A combustion chamber 56 is defined by the cylinder block 50, the cylinder head 51, and the piston 54.

On the right of the crankcase 49, the power generator 44 is disposed. The power generator 44 includes a rotor 58 coupled to the right end portion of the crankshaft 48, and a stator coil 59 supported on the crankcase 49. When the crankshaft 48 rotates, the rotor 58 rotates around the stator coil 59, and an electromotive force is generated in the stator coil 59. By this electromotive force generated in the stator coil 59, the battery 25 (refer to Fig. 1) is charged.

The V-belt type continuously variable transmission 46 includes a transmission case 60, a drive pulley 61, a driven pulley 62, and a V-belt 63 wound around these pulleys. The drive pulley 61 is attached to the left end portion of the crankshaft 48. The driven pulley 62 is attached to a main shaft 65 rotatably around the main shaft 65. In detail, the driven pulley 62 includes a movable pulley piece 62a whose position in the axial direction of the main shaft 65 changes and a fixed pulley piece 62b whose position in the axial direction does not change. Both of the pulley pieces 62a and 62b are rotatable with respect to the main shaft 65. The main shaft 65 is held rotatably on the transmission case 60. Rotation of the main shaft 65 is transmitted to a rear wheel shaft 67 via a gear mechanism 66. The rear wheel shaft 67 is supported rotatably on the transmission case 60. To the rear wheel shaft 67, the rear wheel 4 is fixed.

Rotation of the driven pulley 62 is transmitted to the main shaft 65 via the centrifugal clutch 47. The centrifugal clutch 47 includes a primary side rotor 71 supported rotatably on the main shaft 65 and a secondary side rotor 72 as a clutch plate that is coupled to the main shaft 65 and rotates together with the main shaft 65. The secondary side rotor 72 has a tubular portion surrounding the primary side rotor 71. The driven pulley 62 is coupled to the primary side rotor 71, and the primary side rotor 71 rotates together with the driven pulley 62. However, the movable pulley piece 62a can be freely displaced along the axial direction of the main shaft 65, and a compression coil spring 70 is interposed between the movable pulley piece 62a and the primary side rotor 71. The primary side rotor 71 is provided with a shoe 73. The shoe 73 is configured to come into contact with the inner surface of the tubular portion of the secondary side rotor 72 when the rotation speed of the primary side rotor 71 increases to a predetermined speed. Therefore, when the rotation speed of the driven pulley 62 increases, the shoe 73 comes into contact with the secondary side rotor 72, and accordingly, the rotation of the driven pulley 62 is transmitted to the main shaft 65 via the centrifugal clutch 47, and a driving force is applied to the rear wheel 4.

The drive pulley 61 includes a movable pulley piece 61a disposed in the crankcase 49, and a fixed pulley piece 61b disposed on the side away from the crankcase 49. The movable pulley piece 61a is coupled to the crank shaft 48 so that the movable pulley piece 61a can be displaced in the axial direction of the crankshaft 48 with respect to the crankshaft 48, and rotates together with the crankshaft 48. The fixed pulley piece 61b is fixed to the crankshaft 48, and rotates together with the crankshaft 48 in a state where it is not displaced in the axial direction of the crankshaft 48. On the crankcase 49 side with respect to the movable pulley piece 61a, a holder plate 64 is fixed to the crankshaft 48. A roller 68 is disposed between the holder plate 64 and the movable pulley piece 61 a. The roller 68 is positioned near the rotation center when the rotation speed of the crankshaft 48 is low, and the movable pulley piece 61 a is positioned close to the crankcase 49 accordingly. On the other hand, as the rotation speed of the crankshaft 48 becomes higher, the roller 68 moves away from the rotation center due to a centrifugal force, and presses the movable pulley piece 61a and brings it closer to the fixed pulley piece 61 b.

When the rotation speed of the crankshaft 48, that is, the engine rotation speed is low, and the distance between the movable pulley piece 61a and the fixed pulley piece 61b is long, the V-belt 63 is positioned at a small-diameter position close to the crankshaft 48. Accordingly, on the driven pulley 62, the V-belt 63 is positioned at a large-diameter position away from the main shaft 65. This state is shown in Fig. 3. In this state, the rotation speed of the driven pulley 62 is low, so that the centrifugal clutch 47 is kept in a disconnected state. When the engine rotation speed increases, the roller 68 is displaced by a centrifugal force to move away from the crankshaft 48, and accordingly, the movable pulley piece 61a moves closer to the fixed pulley piece 61b, so that the V-belt 63 moves to a large-diameter position of the drive pulley 61. Accordingly, on the driven pulley 62, the V-belt 63 widens the distance between the movable pulley piece 62a and the fixed pulley piece 62b by pushing these against a force of the compression coil spring 70 and moves to the small-diameter position. As a result, the rotation speed of the driven pulley 62 increases, so that the centrifugal clutch 47 is switched into a connected state, and a driving force of the engine 45 is transmitted to the rear wheel 4. The centrifugal clutch 47 is a rotation speed responsive clutch that is switched into a connected state in response to an engine rotation speed. A minimum engine rotation speed when the centrifugal clutch 47 is switched into a connected state is referred to as "transmission rotation speed."

The starter motor 43 is fixed to the crankcase 49, and is actuated by electric power supplied from the battery 25. The rotative force of the starter motor 43 is transmitted to the crankshaft 48 by the gear mechanism 69 housed in the crankcase 49. Therefore, when starting the engine 45, the starter motor 43 is actuated, and accordingly, the crankshaft 48 is rotated.

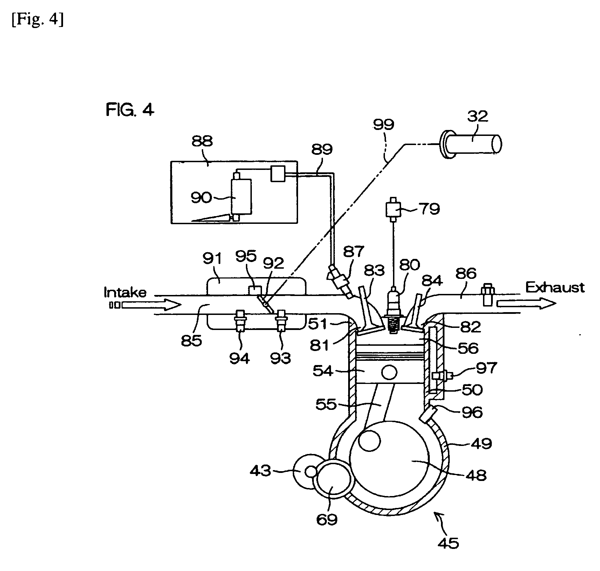

Fig. 4 is a schematic view for describing a configuration relating to the engine 45. On the cylinder head 51, an intake opening 81 and an exhaust opening 82 facing the combustion chamber 56 are defined. Further, on the cylinder head 51, an ignition plug 80 is disposed to face the combustion chamber 56. An intake valve 83 is disposed in the intake opening 81, and an exhaust valve 84 is disposed in the exhaust opening 82. The intake valve 83 opens and closes the intake opening 81, and the exhaust valve 84 opens and closes the exhaust opening 82. The intake valve 83 and the exhaust valve 84 are driven by a valve gear (not illustrated) that interlocks with the crankshaft 48. The intake opening 81 is connected to the intake port 85, and the exhaust opening 82 is connected to the exhaust port 86.

The engine 45 is a fuel injection type engine in the present preferred embodiment. Specifically, in the intake port 85, an injector 87 is disposed on the upstream side of the intake valve 83. The injector 87 is arranged to inject fuel toward the intake opening 81. The injector 87 is supplied with fuel from a fuel tank 88 via a fuel hose 89. Inside the fuel tank 88, a fuel pump 90 is disposed. The fuel pump 90 pressure-feeds fuel inside the fuel tank 88 to the fuel hose 89.

In the intake port 85, a throttle body 91 is disposed on the upstream side of the injector 87. The throttle body 91 holds a throttle valve 92, an intake pressure sensor 93, an intake temperature sensor 94, and a throttle opening degree sensor 95. The throttle valve 92 may be, for example, a butterfly valve including a plate-shaped valve element disposed turnably inside the intake port 85. The throttle valve 92 is mechanically coupled to the accelerator grip 32 via a wire 99 in the present preferred embodiment. Specifically, when the accelerator grip 32 is operated, according to the operation direction and the operation amount, the throttle valve 92 is displaced (in the present preferred embodiment, angular displacement) to change the throttle opening degree. The position of the throttle valve 92 is detected by the throttle opening degree sensor 95. The throttle valve 92 and the accelerator grip 32 are mechanically joined to each other, so that in the present preferred embodiment, the throttle opening degree sensor 95 functions as an accelerator operation detection section that detects an accelerator opening degree as an accelerator command value as well as the throttle opening degree. The accelerator opening degree is an operation amount of the accelerator grip 32. The intake pressure sensor 93 detects the pressure of the intake air. The intake temperature sensor 94 detects the temperature of the intake air.

A crank angle sensor 96 for detecting a rotation angle of the crankshaft 48 is attached to the crankcase 49. An engine temperature sensor 97 for detecting the temperature of the engine 45 is attached to the cylinder block 50.

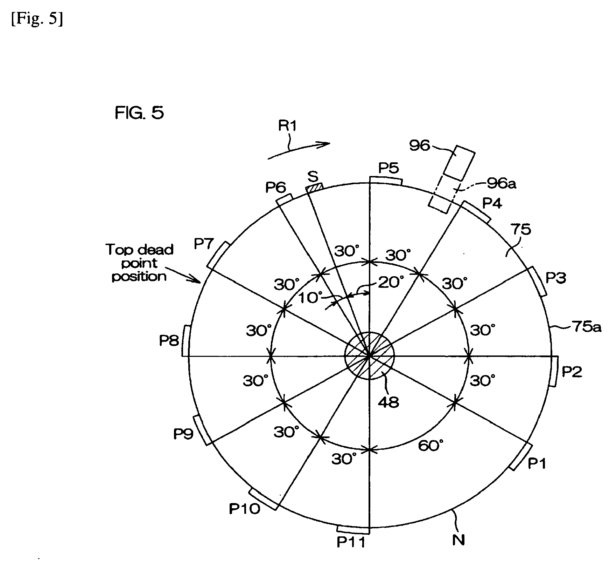

Fig. 5 is a schematic view for describing a configuration for detecting a rotation position or a crank angle of the crankshaft 48. A rotor 75 which is a rotary member for crank angle detection is fixed to the crankshaft 48. As the rotor 75, a rotor 58 for the power generator 44 may be used in common as shown in Fig. 3. A crank angle sensor 96 is disposed to face the rotor 75, and the rotor 75 and the crank angle sensor 96 constitute a crank angle detection unit. The crank angle sensor 96 consists of, for example, an electromagnetic pickup or an optical pickup, and is a detection means that outputs an electric signal responsive to an object passing through the inside of a detection region 96a.

The rotor 75 has an outer peripheral surface 75a circular in a side view along the axial direction of the crankshaft 48. Specifically, the outer peripheral surface 75a has a cylindrical surface along the rotation direction R1 of the crankshaft 48. On the outer peripheral surface 75a, along its circumferential direction, that is, along the rotation direction R1 of the crankshaft 48, first detection bodies P1, P2, ..., P11 are disposed at even intervals. In the present preferred embodiment, the first detection bodies P1, P2, ..., P11 are flat projections (detection teeth) projecting by a predetermined height from the outer peripheral surface 75a toward the outer side of the rotation radius.

The crank angle sensor 96 is disposed so that a path that the outer peripheral surface 75a of the rotor 75 and the first detection bodies P1, P2, ..., P11 pass through crosses the detection region 96a of the crank angle sensor 96. The crank angle sensor 96 outputs a detection signal that changes for each passage of the first detection bodies P1, P2, ..., P11 according to rotation of the rotor 75. Each of the first detection bodies P1, P2, ..., P11 has a front end positioned on the downstream side in the rotation direction R1 and a rear end positioned on the upstream side in the rotation direction R1. When the crankshaft 48 rotates in the rotation direction R1, the front end of each detection body enters the detection region 96a, and then the rear end of this detection body enters the detection region 96a. An output signal of the crank angle sensor 96 changes according to passage of the front end and passage of the rear end of each detection body. In the present preferred embodiment, the rear ends of the first detection bodies P1, P2, ..., P11 are used as detection edges. Specifically, from an output signal of the crank angle sensor 96, signals corresponding to the rear ends of the first detection bodies P1, P2, ..., P11 are extracted as significant signals to generate crank pulses. Therefore, the plurality of first detection bodies P1, P2, ..., P11 are disposed on the outer peripheral surface 75a of the rotor 75 so that rear ends thereof are at even intervals. In detail, eleven first detection bodies P1, P2, ..., P11 are disposed by matching the rear ends thereof with 11 positions of 12 positions arranged by dividing the full angle range of 360 degrees around the crankshaft 48 by 30 degrees into twelve. One position at which the first detection bodies P1, P2, ..., P11 are missing is a tooth-missing position N. The distance between the first detection bodies P1 and P11 before and after the tooth-missing position N is long, so that the crank pulse interval becomes long. Therefore, by detecting the tooth-missing position N, the reference position of the crankshaft 48 can be obtained, and by counting crank pulses generated according to passages of the first detection bodies P1, P2, ..., P11 from the reference position, the rotation position (crank angle) of the crankshaft 48 can be obtained. The tooth-missing position N is a first reference position detection portion that provides a first reference position of the crank angle.

The tooth-missing position N is, for example, disposed at a position such that the tooth-missing position N enters the detection region 96a near a bottom dead point position (a predetermined region including the bottom dead point position). The bottom dead position is defined by a crank angle at which the piston 54 is closest to the crankshaft 48. For example, the first detection body P6 that is sixth from the tooth-missing position N is an energization start detection body that provides a timing to start energization of the ignition coil 79, and the following seventh first detection body P7 is an ignition detection body that provides an ignition timing to cause spark discharge by the ignition plug 80. The ignition detection body P7 is, for example, disposed to face the crank angle sensor 96 just before the top dead point position which is defined by a crank angle at which the piston 54 is farthest from the crankshaft 48. Specifically, the ignition detection body P7 is a first detection body closest to the top dead point position on the downstream side in the rotation direction R1 of the top dead point position among the plurality of first detection bodies P1 to P11.

Between the energization start detection body P6 and the first detection body P5 just before the energization start detection body P6 (that is, the first detection body P5 that passes through the detection region 96a of the crank angle sensor 96 just before the energization start detection body P6), a second detection body S is disposed. Specifically, the second detection body S is disposed so as to pass through the detection region 96a of the crank angle sensor 96 when the rotation position of the crankshaft 48 is just before the top dead point position. In detail, the second detection body S is disposed at a rotation position just before the top dead point position in a rotation position range of 180 degrees or less (in the present preferred embodiment, 90 degrees or less) just before the top dead point position. Specifically, the second detection body S is disposed so as to pass through the detection region 96a of the crank angle sensor 96 in the compression stroke or exhaust stroke (in the present preferred embodiment, in a latter half of the compression stroke or latter half of the exhaust stroke). In addition, the second detection body S is disposed so that the energization start detection body P6 enters the detection region 96a before the ignition detection body P7 enters the detection region 96a after the second detection body S enters the detection region 96a. The disposition of the second detection body S is not limited to the disposition example shown in Fig. 5, and for example, the second detection body S may be disposed between the first detection bodies P4 and P5.

The second detection body S is a flat projection (detection tooth) projecting by a predetermined height from the outer peripheral surface 75a of the rotor 75 outward in the rotation radial direction like the first detection bodies P1, P2, ..., P11. The second detection body S is disposed so that the rear end (edge on the upstream side in the rotation direction R1) that is a detection edge is sufficiently separated from the rear ends of the first detection bodies P5 and P6 before and after the second detection bodys. Further, in the present preferred embodiment, the rear end of the second detection body S is biased toward the side close to the sixth detection body P6 (energization start detection body) with respect to the middle position between the rear ends of the first detection bodies P5 and P6 before and after the second detection body S. In detail, a ratio of the distance from the rear end of the first detection body P5 to the rear end of the second detection body S (angle viewed from the crankshaft 48) with respect to the distance from the rear end of the second detection body S to the rear end of the energization start detection body P6 (angle viewed from the crankshaft 48) is 2 to 1. In the present preferred embodiment, therefore, as viewed from the crankshaft 48, the angle between the rear end of the first detection body P5 and the rear end of the second detection body S is 20 degrees, and the angle between the rear end of the second detection body S and the rear end of the energization start detection body P6 is 10 degrees. Sufficient distances (for example, 5 degrees or more as angles viewed from the crankshaft 48) are secured between the rear end of the first detection body P5 and the front end of the second detection body S and between the rear end of the second detection body S and the front end of the energization start detection body P6. In order to secure this distance, in the present preferred embodiment, the length from the rear end to the front end of the energization start detection body P6 is shorter than that of other first detection bodies P1 to P5 and P7 to P11. Therefore, the front ends of the first detection bodies P1, P2, ..., P11 are not disposed at even intervals in the present preferred embodiment. For example, the first detection bodies P1 to P5 and P7 to P11 have a length of approximately 10 degrees as an angle viewed from the crankshaft 48, and on the other hand, the energization start detection body P6 has a length of approximately 5 degrees as an angle viewed from the crankshaft 48. The length along the rotation direction R1 of the second detection body S is, for example, approximately 5 degrees as an angle viewed from the crankshaft 48.

Therefore, the angle range from the rear end of the fourth detection body P4 to the rear end of the fifth detection body P5 is 30 degrees, the angle range from the rear end of the fifth detection body P5 to the rear end of the second detection body S is 20 degrees, and the angle range from the rear end of the second detection body S to the rear end of the energization start detection body P6 is 10 degrees. The time intervals of the crank pulses depend on the angle ranges, so that the second detection body S can be identified based on the crank pulses. When the second detection body S can be identified, the energization start detection body P6 just after the second detection body S can be identified, so that immediately after the second detection body S is identified, energization of the ignition coil 79 can be started. Specifically, the second detection body S is a second reference position detection portion that provides a second reference position of the crank angle just before the energization start detection body P6.

The rotation load of the engine 45 becomes highest just before the compression top dead point. Therefore, the angle position of the crankshaft 48 when the engine 45 stops is before the compression top dead point in many cases. In detail, a load when the first detection body P7 (ignition detection body) just before the compression top dead point faces the crank angle sensor 96 is maximum, and the engine 45 stops at an angle position about 90 degrees before the angle position corresponding to the maximum load in many cases. Specifically, as shown in Fig. 5, it is highly probable that when the engine 45 stops, the range from the fourth first detection body P4 to the fifth first detection body P5 from the tooth-missing position N is positioned in the detection region 96a of the crank angle sensor 96.

Therefore, in the present preferred embodiment, the second detection body S is disposed between the fifth first detection body P5 and the following energization start detection body P6. When cranking is started from the state shown in Fig. 5, the angle from the rear end of the fifth first detection body P5 to the rear end of the second detection body S and the angle from the second detection body S to the sixth first detection body P6 are greatly different from each other, so that the second detection body S can be identified based on the output signal of the crank angle sensor 96, and accordingly, a reference position for crank angle detection can be provided. Based on this reference position, the energization start detection body P6 and the ignition detection body P7 can be identified immediately and ignition control for engine start can be started immediately.

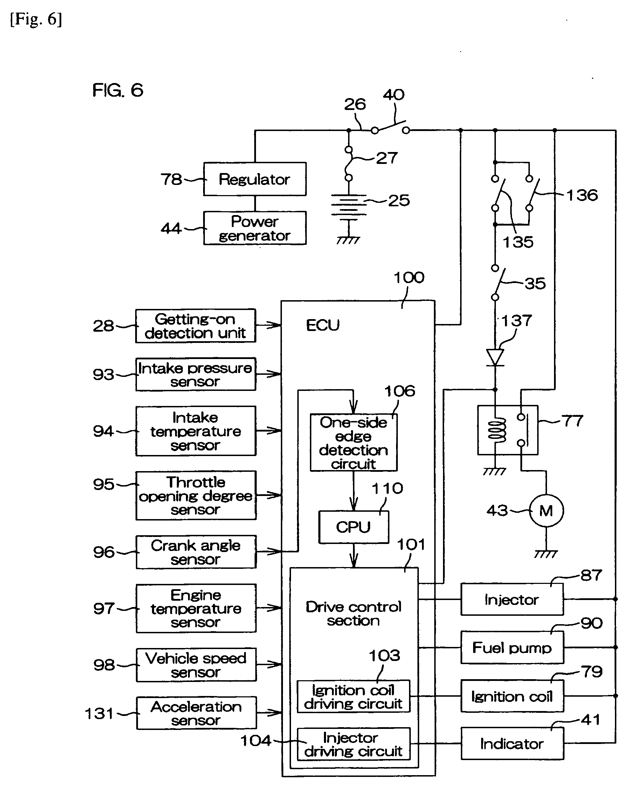

Fig. 6 is a block diagram for describing an electrical configuration relating to control of the engine 45. Outputs of the sensors 93 to 97 are input into the ECU (electronic control unit) 100. To the ECU 100, other sensors such as a vehicle speed sensor 98, an acceleration sensor 131, etc., may be connected as appropriate. The vehicle speed sensor 98 is a sensor that detects the vehicle speed of the motorcycle 1, and may be a wheel speed sensor that detects rotation speeds of the wheels 3 and 4. The acceleration sensor 131 is a sensor that detects the acceleration of the motorcycle 1. To the ECU 100, a getting-on detection unit 28 for detecting whether a driver has sat on the seat 7 (refer to Fig. 1), that is, whether a driver has got on the motorcycle, is connected. The getting-on detection unit 28 may be a load detection unit that detects a load (weight) applied onto the seat 7 as illustrated in Fig. 1. An example of the load detection unit is a seat switch that becomes conductive when a load of a predetermined value or more is applied onto the seat 7.

The ECU 100 includes an interface circuit for taking-in signals output from the sensors 28, 93 to 98, and 131. The interface circuit includes a one-side edge detection circuit 106 that shapes the waveform of the output signal of the crank angle sensor 96 and generates crank pulses. The one-side edge detection circuit 106 detects signals corresponding to the rear ends of the first detection bodies P1 to P11 and the second detection body S from the output signal of the crank angle sensor 96 and generates crank pulses.

The ECU 100 includes a CPU 110. Based on output signals of the sensors 93 to 97, etc., the CPU 110 drives the fuel pump 90 and the injector 87 to control the fuel injection amount and the fuel injection timing. To the ECU 100, an ignition coil 79 is further connected. The ignition coil 79 stores electric power for causing spark discharge of the ignition plug 80 (refer to Fig. 4). The CPU 110 controls energization of the ignition coil 79 based on output signals of the sensors 93 to 97, etc., to control the ignition time (discharge timing of the ignition plug 80).

Further, the CPU 110 controls energization of the starter motor 43 to control the start of the engine 45.

The battery 25 is connected to a power supply line 26 via a fuse 27. The electric power stored in the battery 25 is supplied to the starter motor 43, the ECU 100, the ignition coil 79, the injector 87, the fuel pump 90, the indicator 41, etc., via the power supply line 26. The battery 25 is supplied with electric power that is generated by the power generator 44 and rectified and regulated by the regulator 78, and accordingly, during driving of the engine 45, the battery 25 is charged.

The main switch 40 is interposed in the power supply line 26. To the power supply line 26, on the side opposite to the battery 25 with respect to the main switch 40, a parallel circuit of brake switches 135 and 136 is connected. The brake switch 135 becomes conductive when the rear wheel brake lever 38 is operated, and is shut off when the rear wheel brake lever 38 is not operated. Similarly, the brake switch 136 becomes conductive when the front wheel brake lever 39 is operated, and is shut off when the front wheel brake lever 39 is not operated. The starter button 35 is connected in series to the parallel circuit of these brake switches 135 and 136, a diode 137 is connected in series to the starter button 35, and further, a coil of a relay 77 is connected to the diode 137. To the power supply line 26, the starter motor 43 is connected via the relay 77. Therefore, when the starter button 35 is turned on in a state where the rear wheel brake lever 38 or the front wheel brake lever 39 is operated, the relay 77 becomes conductive and the electric power of the battery 25 is supplied to the starter motor 43.

In the power supply line 26, to the side opposite to the battery 25 with respect to the main switch 40, the ECU 100, the ignition coil 79, the injector 87, the fuel pump 90, the indicator 41, etc., are connected. Specifically, when the main switch 40 becomes conductive, the electric power is supplied to the ECU 100, and the control operation of the ECU 100 is started.

The ECU 100 includes a drive control section 101 for driving actuators including the ignition coil 79, the injector 87, the fuel pump 90, the relay 77, the indicator 41, etc. The drive control section 101 includes a plurality of driving circuits for energizing the actuators. The plurality of driving circuits include an ignition coil driving circuit 103 for energizing the ignition coil 79 and an injector driving circuit 104 for driving the injector 87. The CPU 110 controls energization of the actuators by controlling these driving circuits.

Between the diode 137 and the coil of the relay 77, the drive control section 101 of the ECU 100 is connected. Therefore, the ECU 100 can actuate the starter motor 43 by driving the relay 77 even when the starter button 35 is off.

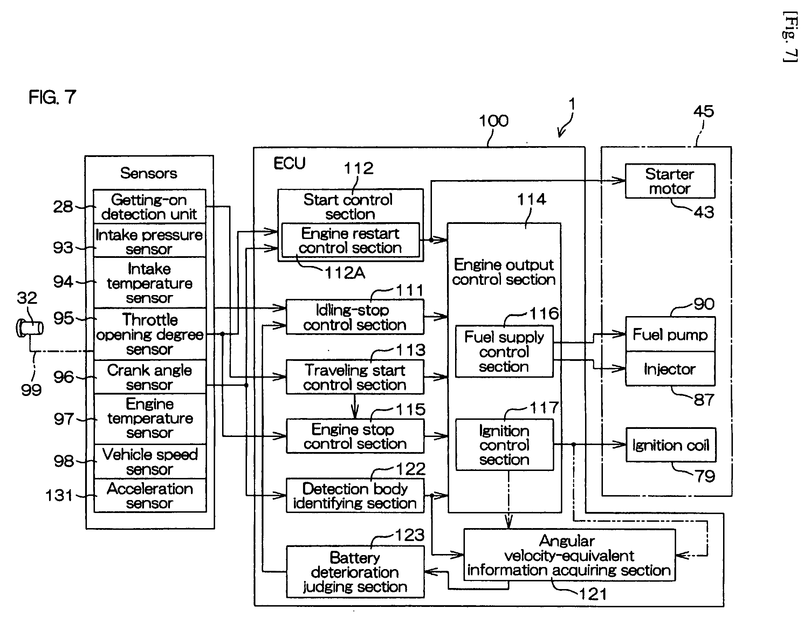

Fig. 7 is a block diagram for describing a functional configuration of the ECU 100. The ECU 100 and the sensors 28, 93 to 98, and 131 constitute an engine control device for controlling the engine 45. As described above, the ECU 100 includes the CPU 110 installed inside, and by execution programs by the CPU 110, the functions of the functional processing sections described as follows are realized.

Specifically, the ECU 100 includes, as functional processing sections, an idling-stop control section 111, a start control section 112, a traveling start control section 113, an engine output control section 114, and an engine stop control section 115. The ECU 100 further includes an angular velocity-equivalent information acquiring section 121, a detection body identifying section 122, and a battery deterioration judging section 123.

The engine output control section 114 controls the output of the engine 45. In detail, the engine output control section 114 includes a fuel supply control section 116 and an ignition control section 117. The fuel supply control section 116 controls the fuel injection amount and the fuel injection timing by controlling the fuel pump 90 and the injector 87. The ignition control section 117 controls a spark discharge time (ignition time) of the ignition plug 80 by controlling energization of the ignition coil 79. By controlling one or both of the fuel injection amount and the ignition time, the output of the engine 45 can be controlled. By cutting-off the fuel by setting the fuel injection amount to zero, the engine 45 can be stopped.

The idling-stop control section 111 stops the engine 45 and switches the engine into an idling-stop state when predetermined idling-stop conditions are satisfied during an idling state of the engine 45. The idling state is a state where the throttle opening degree is a full closing degree and the engine rotation speed is in an idling rotation speed range (for example, 2500 rpm or less). The idling-stop state is a state where the driving of the engine 45 is automatically stopped by control of the idling-stop control section 111. In detail, the idling-stop control section 111 stops fuel supply to the engine 45 by providing a fuel cut-off command to the engine output control section 114, and accordingly stops the engine 45.

The start control section 112 judges that cranking is being performed when it receives crank pulses input in a stopped state of the engine 45, and performs control for engine start. Specifically, the start control section 112 commands the engine output control section 114 to perform fuel supply control and ignition control. Accordingly, in synchronization with the rotation of the crankshaft 48, fuel is injected by the injector 87 and energization of the ignition coil 79 is controlled, and the engine 45 is started. The start control section 112 includes an engine restart control section 112A. The engine restart control section 112A restarts the engine 45 when a predetermined operation of the accelerator grip 32 is detected during the idling-stop state of the engine 45. Restart means restarting the engine 45 being in an idling-stop state. In detail, the engine restart control section 112 actuates the starter motor 43 by making the relay 77 (see Fig. 6) conductive by controlling the drive control section 101 and applies fuel supply control and an ignition control command to the engine output control section 114. Accordingly, the starter motor 43 is actuated and fuel is injected from the injector 87, and the ignition coil 79 spark-discharges and the engine 45 restarts.

The traveling start control section 113 permits the motorcycle 1 to start traveling on the condition that getting-on of a driver has been detected by the getting-on detection unit 28 after the engine 45 is restarted. In other words, the traveling start control section 113 prohibits traveling start of the motorcycle 1 unless getting-on of a driver is detected by the getting-on detection unit 28. In detail, prohibiting traveling start means a state where a driving force of the engine 45 is not transmitted to the rear wheel 4. Therefore, permitting traveling start means a state where transmission of a driving force of the engine 45 to the rear wheel 4 is permitted.

In detail, the traveling start control section 113 provides a command (output inhibiting command) to inhibit an output of the engine 45 to the engine output control section 114. The engine output control section 114 that received the output inhibiting command controls the output of the engine 45 so that the rotation speed of the engine 45 becomes lower than a predetermined transmission rotation speed. As described above, the transmission rotation speed is a lowest engine rotation speed for switching the centrifugal clutch 47 (see Fig. 3) as an example of a rotation speed responsive clutch into a connected state where the centrifugal clutch 47 transmits the rotation of the primary side rotor 71 to the secondary side rotor 72. Therefore, when the engine rotation speed is kept lower than the transmission rotation speed, the centrifugal clutch 47 is kept in a shut-off state where the primary side rotor 71 and the secondary side rotor 72 rotate independently of each other, and the driving force of the engine 45 is not transmitted to the rear wheel 4. The engine output control section 114 keeps the engine rotation speed lower than the transmission rotation speed regardless of the throttle opening degree by inhibiting the output of the engine 45 by performing one or both of control of the fuel injection amount and control of the ignition time when the engine output control section 114 receives an output inhibiting command.

After the engine 45 is restarted by the engine restart control section 112A, when the traveling start control section 113 does not permit the motorcycle 1 to start traveling, the engine stop control section 115 stops the engine 45 in response to detection of a predetermined engine stop trigger operation. An example of the engine stop trigger operation may be an operation of the accelerator grip 32 for quickly closing or quickly opening the throttle. This operation can be detected by monitoring the output of the throttle opening degree sensor 95 that also serves as an accelerator operation detection section. Specifically, when the throttle opening degree change rate is a predetermined value or more, it can be judged that an accelerator operation for quickly closing or quickly opening the throttle has been performed. Another example of the engine stop trigger operation may be a predetermined amount or more of operation of the accelerator grip 32. For example, by judging that the throttle opening degree has reached a predetermined value or more from the output of the throttle opening degree sensor 95, it can be judged that the predetermined amount or more of operation of the accelerator grip 32 has been performed. When an engine stop trigger operation is detected, the engine stop control section 115 provides a fuel cut-off command to the engine output control section 114. In response to this, the engine output control section 114 sets the fuel injection amount to zero, and accordingly, the fuel supply to the engine 45 is cut off and driving of the engine 45 is stopped.

The detection body identifying section 122 is a detection body identifying means that identifies the detection bodies P1 to P11 and S detected by the crank angle sensor 96 based on crank pulses generated by the one-side edge detection circuit 106 (refer to Fig. 6) based on an output signal of the crank angle sensor 96. In detail, based on intervals of the crank pulses generated responsive to passages of the rear ends of the detection bodies P1 to P11 and S, the detection body identifying section 122 detects the tooth-missing position N or the second detection body S as a reference position. Then, by counting crank pulses from the reference position, the detection body identifying section 122 identifies the energization start detection body P6 and the ignition detection body P7. The identification results are given to the ignition control section 117.

When the energization start detection body P6 is detected, the ignition control section 117 starts energization of the ignition coil 79. When the ignition detection body P7 is detected, the ignition control section 117 cuts-off energization of the ignition coil 79. Accordingly, energy stored in the ignition coil 79 is supplied to the ignition plug 80, and the ignition plug 80 causes spark discharge inside the combustion chamber 56. When ignition time control (retarding control) is performed, the ignition control section 117 stops energization of the ignition coil 79 at a timing shifted from the detection timing of the ignition detection body P7, and causes spark discharge of the ignition plug 80 at this shifted timing.

The angular velocity-equivalent information acquiring section 121 is an angular velocity-equivalent information acquiring means that acquires information equivalent to the angular velocity of the crankshaft 48 at the time of start (including restart) of the engine 45. In detail, at the time of cranking of the engine 45, the angular velocity-equivalent information acquiring section 121 acquires information elquivalent to an angular velocity of the crankshaft 48 just before the top dead point position (preferably, just before the compression top dead point position). In detail, in the present preferred embodiment, the angular velocity-equivalent information acquiring section 121 measures a time during which the ignition coil 79 is energized (ignition coil energization time) as an index that indicates the angular velocity. The angular velocity-equivalent information acquiring section 121 may measure the time from detection of the energization start detection body P6 by the detection body identifying section 122 to detection of the ignition detection body P7. This time corresponds to the ignition coil energization time. The distance between the energization start detection body P6 and the ignition detection body P7 is fixed, so that the time from detection of the energization start detection body P6 to the detection of the ignition detection body P7 is in inverse proportion to the angular velocity of the crankshaft 48. Therefore, this time can be used as an index that indicates the angular velocity of the crankshaft 48 just before the top dead point position. The angular velocity-equivalent information acquiring section 121 may measure a time during which the ignition control section 117 generates a command of energization of the ignition coil 79 as an ignition coil energization time. The ignition control section 117 generates an energization command during the time from detection of the energization start detection body P6 to detection of the ignition detection body P7. The distance between the energization start detection body P6 and the ignition detection body P7 is fixed, so that the time during which an energization command is issued is in inverse proportion to the angular velocity of the crankshaft 48. Therefore, the time during which the energization command is issued can be used as an index that indicates an angular velocity of the crankshaft 48 just before the top dead point position. For the same reason, the angular velocity-equivalent information acquiring section 121 may measure a time during which the ECU 100 actually energizes the ignition coil 79 (an actual ignition coil energization time). This actual ignition coil energization time can also be used as an index that indicates the angular velocity of the crankshaft 48 just before the top dead point position.

The battery deterioration judging section 123 is a battery deterioration judging means that judges whether the battery 25 has deteriorated based on information equivalent to an angular velocity (ignition coil energization time) acquired by the angular velocity-equivalent information acquiring section 121. When the battery 25 deteriorates, the angular velocity of the crankshaft 48 becomes smaller due to a cranking load when starting. Therefore, the battery deterioration judging section 123 judges that the battery 25 has deteriorated when the angular velocity of the crankshaft 48 when starting is smaller than a predetermined threshold.

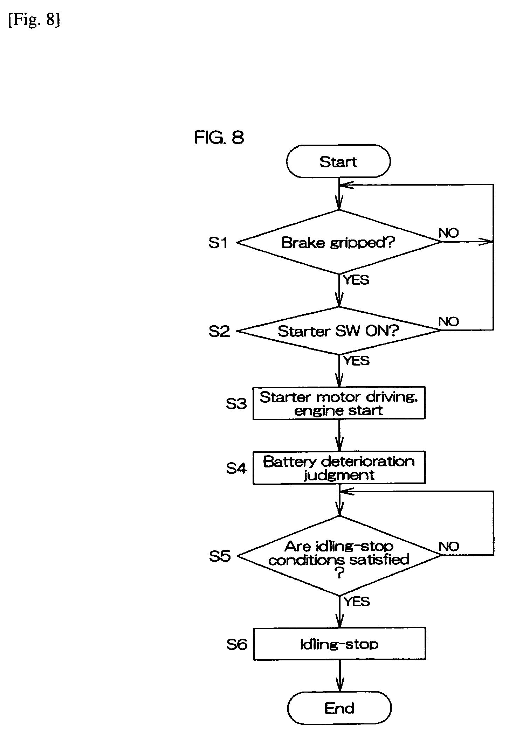

Fig. 8 is a flowchart for describing the flow from the start of the engine 45 to switching into the idling-stop state. In the case where the main switch 40 is conductive, when the starter button 35 is operated (Step S2) while the rear wheel brake lever 38 or the front wheel brake lever 39 is gripped (step S1), the relay 77 becomes conductive to supply the electric power of the battery 25 to the starter motor 43. Accordingly, the starter motor 43 is driven, and crank pulses from the crank angle sensor 96 are input into the ECU 100. Based on the crank pulses, the ECU 100 identifies the energization start detection body P6 and the ignition detection body P7, and based on the identification results, performs fuel injection control and ignition control. Accordingly, the engine 45 starts and enters a driving state (Step S3).

The ECU 100 judges whether the battery 25 has been deteriorated in a period during which the starter motor 43 is energized and a cranking operation is performed, and writes a battery deterioration judgment flag that indicates whether the battery has been deteriorated in a memory installed inside (Step S4). The state where the battery 25 has deteriorated is a state where electric power sufficient for enabling the starter motor 43 to start the engine 45 cannot be supplied from the battery 45. Specifically, not only the case where the battery 25 has deteriorated in performance due to aging, etc., but also the case where the output voltage of the battery 25 decreases due to discharge of the battery 25 are also included in the state where the battery 25 has deteriorated. The process in Step S4 is a process of writing a judgment flag indicating the battery deterioration state in a memory installed inside.

When the engine 45 is in a driving state, the ECU 100 judges whether predetermined idling-stop conditions are satisfied (Step S5). When the idling-stop conditions are satisfied, the ECU 100 switches the engine 45 into an idling-stop state (Step S6). Specifically, fuel supply to the engine 45 is stopped and the fuel injection control and ignition control are stopped.

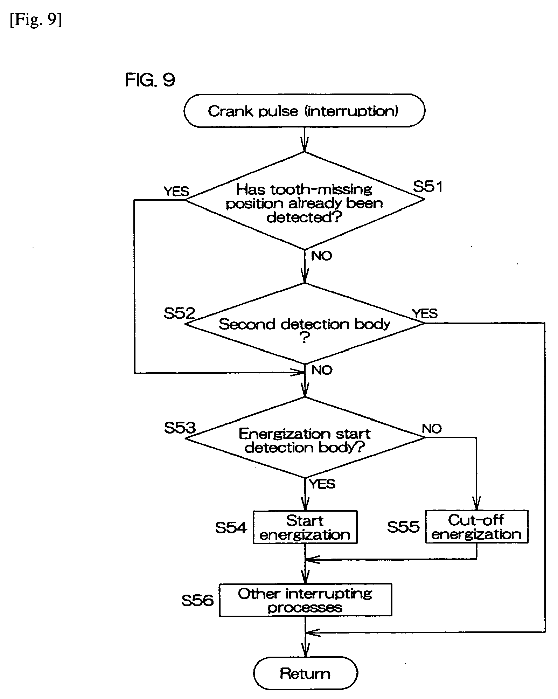

Fig. 9 is a flowchart for describing details of engine start control. The CPU 110 executes an interrupting process for each input of a crank pulse. First, the CPU 110 judges whether the tooth-missing position N has already been detected (Step S51). When the tooth-missing position N has already been detected (Step S51: YES), the CPU 110 judges whether the crank pulse corresponds to the energization start detection body P6 (Step S53). That is, the CPU 110 judges whether the detection body detected by the crank angle sensor 96 is the energization start detection body P6. When it is the energization start detection body P6 (Step S53: YES), the CPU 110 starts energization of the ignition coil 79 (Step S54), and otherwise (Step S53: NO), the CPU 110 cuts-off energization of the ignition coil 79 (Step S55). That is, when energization of the ignition coil 79 has already been cut off, the CPU 110 keeps this cut-off state, and when the ignition coil 79 is being energized, the CPU 110 cuts-off the energization. By cutting-off the energization, the energy stored in the ignition coil 79 is supplied to the ignition plug 80, and spark discharge occurs on the ignition plug 80. Thereafter, other interrupting processes are further performed (Step S56).

Other interrupting processes (Step S56) include identifications of the detection bodies P1 to P5, P7 to P11, and S corresponding to crank pulses that caused the interruptions, detection of the tooth-missing position N, fuel injection control, etc. The identifications of the detection bodies include identification of the second detection body S.

When the tooth-missing position N has not been detected yet (Step S51: NO), the second detection body S may be identified earlier than the tooth-missing position N (Step S52). In this case, by using the position of the second detection body S as a reference position, the energization start detection body P6 is identified (Step S53). Therefore, without waiting for detection of the tooth-missing position N, the energization of the ignition coil 79 can be controlled. Specifically, when the engine starts, by using either one detected earlier of the tooth-missing position N and the second detection body S as a reference, the energization start detection body P6, etc., are identified.

On the other hand, after the tooth-missing position N is detected (Step S51: YES), the interrupting process in response to a crank pulse corresponding to the second detection body S is omitted. Therefore, when the tooth-missing position N is detected earlier than the second detection body S when the engine starts, by using the tooth-missing position N exclusively as a reference, ignition control, fuel injection control, and other interrupting processes are performed. When the second detection body S is detected earlier than the tooth-missing position N when the engine starts, identification of the energization start detection body P6 just after the detection of the second detection body S is performed by using the position of the second detection body S as a reference. However, the tooth-missing position N is detected earlier than the next detection of the second detection body S, so that after this, the first detection bodies P1 to P11 are identified by using the tooth-missing position N as a reference.

The second detection body S is disposed just before the energization start detection body P6, so that when the engine starts, the second detection body S can reliably provide a reference position before the energization start detection body P6 passes through the detection region 96a of the crank angle sensor 96 for the first time. Accordingly, ignition control can be quickly started when the engine starts. On the other hand, after the engine starts, it is more proper that the reference position for identifying the first detection bodies P1 to P11 is provided not by the second detection body S but by the tooth-missing position N. The reason for this is that the second detection body S is disposed so as to be detected at a position near the top dead point position by the crank angle sensor 96, and the tooth-missing position N is disposed so as to be detected at a position near the bottom dead point position by the crank angle sensor 96. Specifically, the rotation of the crankshaft 48 is more stable when the tooth-missing position N is detected by the crank angle sensor 96 than when the second detection body S is detected by the crank angle sensor 96. Therefore, after starting of the engine 45 is completed, by using the tooth-missing position N as a reference position, the detection bodies P1 to P11 can be identified more accurately, so that the engine 45 can be controlled more accurately.

Further, when it is tried to perform control after starting of the engine is completed based on a reference position provided by the second detection body S, the existing system in which the tooth-missing position is set near the bottom dead point position must be greatly changed. Therefore, by performing the control after starting of the engine is completed by using the tooth-missing position as a reference, the cost required to change the system can be minimized.

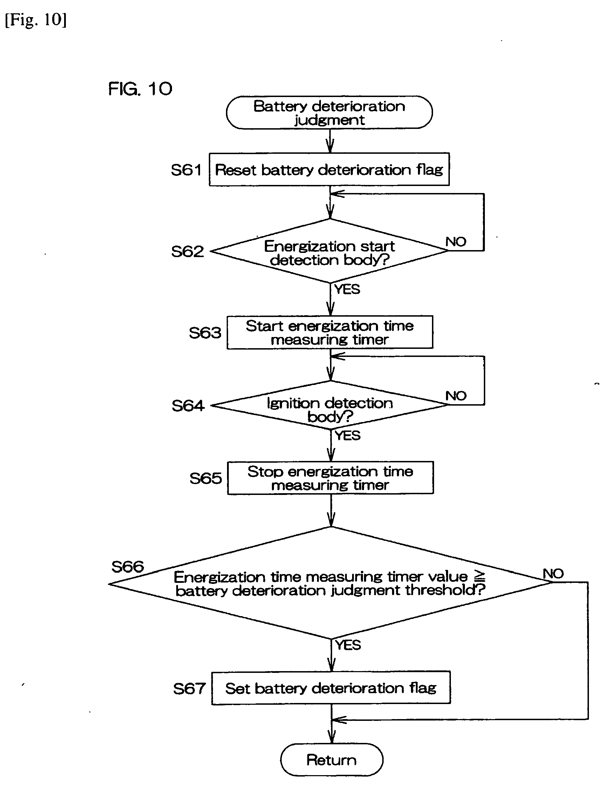

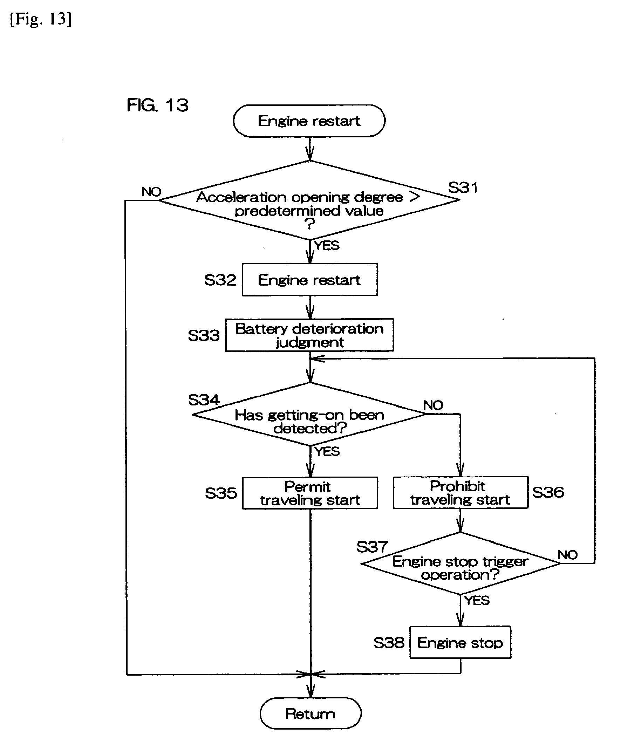

Fig. 10 is a flowchart for describing a detailed example of judgment on deterioration of the battery 25. This process is performed when starting the engine 45 and when restarting the engine 45 (refer to Step S4 in Fig. 8 and Step S33 in Fig. 13 described later). The CPU 110 resets the battery deterioration flag (Step S61), and waits for detection of the energization start detection body P6 (Step S62). When the energization start detection body P6 is detected, the CPU 110 starts the energization time measuring timer (Step S63). Then, the CPU 110 waits for detection of the ignition detection body P7 (Step S64). When the ignition detection body P7 is detected, the CPU 110 stops the energization time measuring timer (Step S65). Therefore, the energization time measuring timer measures the time from detection of the energization start detection body P6 to detection of the ignition detection body P7 by the crank angle sensor 96. This time can be used as an index that indicates the angular velocity of the crankshaft 48 as described above. This time also corresponds to an energization time of the ignition coil 79 as described above.

The CPU 110 compares a measured value measured by the energization time measuring timer with a predetermined battery deterioration judgment threshold (Step S66). When the measured value measured by the energization time measuring timer is equal to or more than the battery deterioration judgment threshold (Step S66: YES), the angular velocity of the crankshaft 48 when cranking is equal to or less than an angular velocity threshold corresponding to the battery deterioration judgment threshold. Then, the CPU 110 raises a battery deterioration flag (Step S67). When the measured value measured by the energization time measuring timer is less than the battery deterioration judgment threshold (Step S66: NO), the angular velocity of the crankshaft 48 when cranking is sufficient, so that the battery deterioration flag is kept in a reset state.

Thus, when the battery 25 has deteriorated and cannot supply sufficient electric power, the rotation speed of the crankshaft 48 that is rotated by the starter motor 43 decreases, so that by utilizing this phenomenon, deterioration of the battery 25 can be judged.

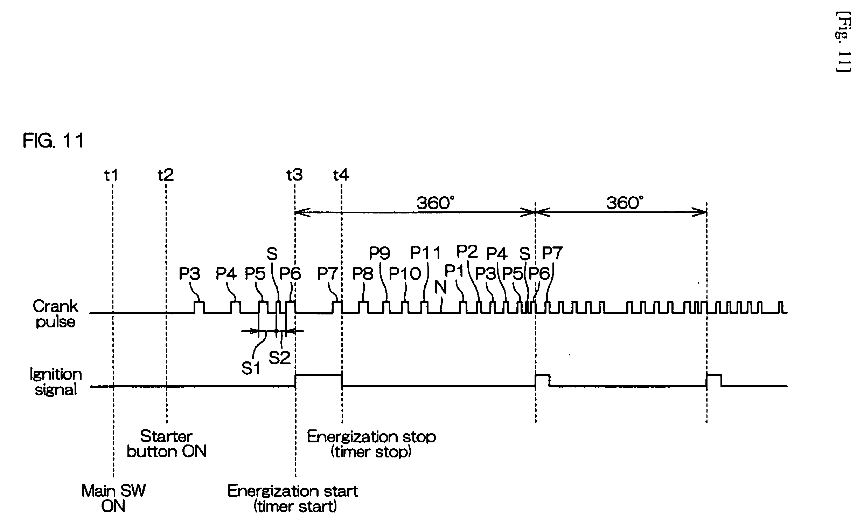

Fig. 11 is a waveform chart showing waveform examples of crank pulses and an ignition signal when the engine starts. The main switch 40 is made conductive at the timing t1, and the starter button 35 is operated at the timing t2. Accordingly, rotation of the crankshaft 48 starts, and according to passages of the detection bodies P1 to P11 and S, crank pulses are generated. In the example of Fig. 11, a crank pulse corresponding to the rear end of the first detection body P3 that is third from the tooth-missing position N is generated first. After crank pulses corresponding to the rear ends of the fourth first detection body P4 and the fifth first detection body P5 are generated, a crank pulse corresponding to the rear end of the second detection body S is generated, and subsequently, a crank pulse corresponding to the rear end of the energization start detection body P6 is generated. For example, the CPU 110 identifies the second detection body S based on intervals between crank pulses before and after each crank pulse. Specifically, the second detection body S is biased toward the first detection body P6 side between the first detection bodies P5 and P6. Therefore, the magnitude relationship between the crank pulse intervals s1 and s2 before and after the crank pulse corresponding to the second detection body S can be distinguished from the magnitude relationships between the crank pulse intervals before and after other crank pulses. Accordingly, the second detection body S can be identified.

After the second detection body S is identified, the CPU 110 starts energization of the ignition coil 79 at the timing t3 in synchronization with a crank pulse corresponding to the energization start detection body P6. Then, in synchronization with a crank pulse corresponding to the ignition detection body P7 that is detected next to the energization start detection body P6, the CPU 110 stops the energization of the ignition coil 79 at the timing t4. Further, the CPU 110 measures the energization time of the ignition coil 79 by starting the energization time measuring timer at the timing t3 and stopping the energization time measuring timer at the timing t4.

Thereafter, crank pulses corresponding to the first detection bodies P8 to P11 are generated, and the CPU 110 performs necessary processes at the respective angle positions. After the first detection body P11, the tooth-missing position N faces the crank angle sensor 96, so that until the crank pulse of the first detection body P1 to be detected next, a long time interval is generated. By monitoring the time intervals of the crank pulses, the CPU 110 detects the tooth-missing position N. Thereafter, by using the tooth-missing position N as a reference position, crank pulses corresponding to the first detection bodies P1 to P11 are counted, and at angle positions corresponding to the first detection bodies P1 to P11, necessary processes are performed.

Unless the second detection body S is provided, the first detection bodies P1 to P11 cannot be identified until the tooth-missing position N is detected. Therefore, the energization start detection body P6 is identified for the first time after the crankshaft 48 has rotated substantially 360 degrees, and then ignition control is started. Therefore, the time until the engine 45 starts becomes long. On the other hand, in the configuration of the present preferred embodiment in which the second detection body S is provided, the ignition control can be started by identifying the energization start detection body P6 before the crankshaft 48 rotates 360 degrees, so that the starting performance of the engine 45 can be improved.

In addition, the energization start detection body P6 can be quickly identified, so that an energization time as angular velocity-equivalent information for battery deterioration judgment can be quickly measured. Therefore, information equivalent to the angular velocity of the crankshaft 48 immediately after the starter motor 43 is actuated can be acquired, so that deterioration of the battery 25 can be properly judged. After the crankshaft 48 rotates 360 degrees, the rotation of the crankshaft 48 becomes faster, so that the accuracy of the battery deterioration judgment based on information equivalent to the angular velocity may be deteriorated.

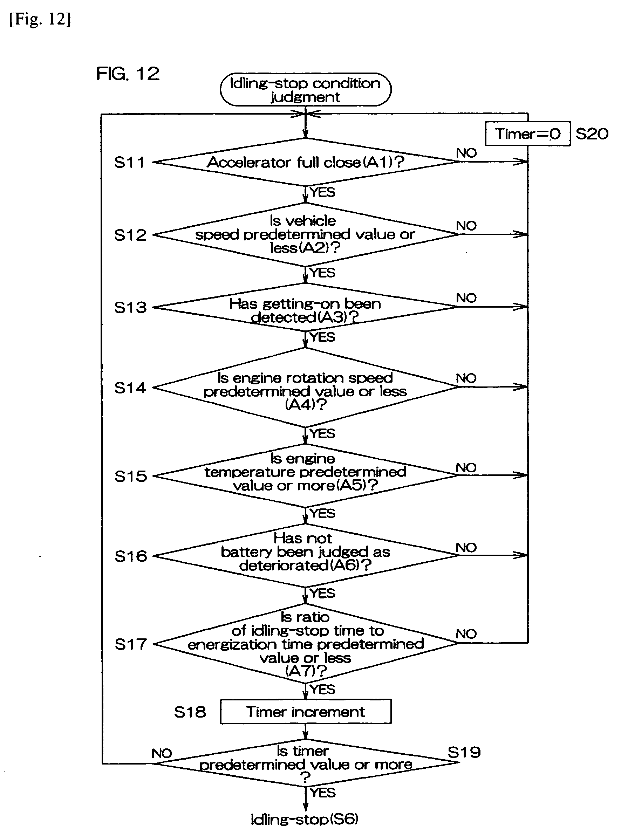

Fig. 12 is a flowchart for describing a detailed example of judgment of idling-stop conditions (Step S5 in Fig. 8). The CPU 110 judges whether the following conditions A1 to A7 are all satisfied (Steps S11 to S17).

Condition A1: The accelerator grip 32 is at a full-closing position. This condition is for confirming that a driver does not intend to transmit a driving force of the engine 45 to the rear wheel 4 that is a drive wheel. In the present preferred embodiment, the accelerator grip 32 and the throttle valve 92 are mechanically interlocked with each other by the wire 99, so that when the throttle opening degree sensor 95 detects full closing of the throttle valve 92, the accelerator grip 32 is at a full-closing position.

Condition A2: The vehicle speed is a predetermined value (for example, 3 km/h) or less. This condition is for confirming that the motorcycle 1 has stopped. In detail, the condition is that the vehicle speed sensor 98 detects a vehicle speed of a predetermined value or less.

Condition A3: Getting-on of a driver has been detected. Getting-on of a driver is detected by the getting-on detection unit 28. If the getting-on detection unit 28 malfunctions and the output thereof is not supplied to the ECU 100, getting-on of a driver is not detected. As described above, to restart the engine 45 in an idling-stop state, getting-on of a driver must be detected. If the getting-on detection unit 28 malfunctions and cannot detect getting-on of a driver, after the engine is switched into an idling-stop state, the engine 45 cannot be restarted. This failure can be avoided by the condition A3. Specifically, when the getting-on detection unit 28 malfunctions, the engine is not switched into an idling-stop state, so that a restart failure from the idling-stop state does not occur.

Condition A4: The engine rotation speed is a predetermined value (for example, 2500 rpm) or less. This condition is for confirming that the engine rotation speed is in an idling rotation speed range. The ECU 100 calculates an engine rotation speed based on a crank pulse generation period output by the crank angle sensor 96, for example.

Condition A5: The engine temperature is a predetermined value (for example, 60 degree) or more. This condition is for confirming that the engine 45 has been sufficiently warmed up, and can be easily restarted after the driving thereof is stopped. The ECU 100 judges the engine temperature based on an output signal of the engine temperature sensor 97.

Condition A6: The battery has not been deteriorated. Specifically, the judgment of the condition A6 may be judgment as to whether a battery deterioration judgment flag has been raised.

Condition A7: A ratio of an idling-stop time to an energization time is a predetermined value (for example, 40%) or less. The energization time is a time during which the main switch 40 is conductive, the motorcycle 1 is powered on, and the electric system of the motorcycle 1 is energized. The idling-stop time is a cumulative time during which the engine 45 is in an idling-stop state. In the present preferred embodiment, an idling-stop time in an energization time of the last 20 minutes, approximately, is measured, and based on this, a ratio of the idling-stop time to the energization time (approximately 20 minutes) is calculated.

When all of the conditions A1 to A7 are satisfied (YES in all of Steps S11 to S17), the CPU 110 increments a timer installed inside (Step S18) and judges whether the value of the timer has reached a predetermined value (for example, a value corresponding to 3 seconds) (Step S19). The timer measures a duration of a state where all of the conditions A1 to A7 are satisfied. When at least one of the conditions A1 to A7 is not satisfied (NO in any of Steps S11 to S17), the CPU 110 resets the timer to zero (Step S20). When the time measured by the timer reaches the predetermined value (for example, a value corresponding to 3 seconds), the CPU 110 judges that the idling-stop conditions have been satisfied and switches the engine 45 into an idling-stop state (Step S6). Specifically, the idling-stop condition is continuation of a state where all of the conditions A1 to A7 are satisfied for a predetermined time. In the idling-stop state, the ECU 110 turns the indicator 41 on.

Fig. 13 is a flowchart for describing an example of control for restarting the engine 45 being in an idling-stop state. The CPU 110 judges whether the operation amount of the accelerator grip 32, that is, the accelerator opening degree has exceeded a predetermined value by monitoring the output of the throttle opening degree sensor 95 (Step S31). When the accelerator opening degree does not exceed the predetermined value, the idling-stop state is continued. When the accelerator opening degree exceeds the predetermined value, the CPU 110 restarts the engine 45 (Step S32). Specifically, the CPU 110 actuates the starter motor 43 by making the relay 77 conductive, and starts the fuel injection control and ignition control. Accordingly, the engine 45 restarts.

The CPU 110 judges whether the battery 25 has been deteriorated during a period in which the starter motor 43 is energized and a cranking operation is performed, and writes a battery deterioration judgment flag indicating whether the battery has been deteriorated in the memory installed inside (Step S33). Details of this operation are the same as those in Step S4 of Fig. 8 (see Fig. 10).

After restarting the engine 45, the CPU 110 judges whether a driver has got on the vehicle, that is, whether a driver has sat on the seat 7 by referring to the output of the getting-on detection unit 28 (Step S34). When a driver gets on the vehicle (Step S34: YES), the CPU 110 establishes a traveling start permitting state (Step S35). Specifically, the CPU 110 permits the engine rotation speed to increase over the transmission rotation speed. Therefore, the accelerator opening degree is increased by the operation of the accelerator grip 32, and in response to this, the throttle opening degree increases and the output of the engine 45 increases, and then, the engine rotation speed reaches the transmission rotation speed. Accordingly, the centrifugal clutch 47 is switched into a connected state, and the driving force of the engine 45 is transmitted to the rear wheel 4.

On the other hand, when getting-on of a driver is not detected by the getting-on detection unit 28 (Step S34: NO), the CPU 110 establishes a traveling start prohibiting state (Step S36). In the traveling start prohibiting state, even when the driver increases the accelerator opening degree and the throttle opening degree accordingly increases, the output of the engine 45 is limited, and the engine rotation speed does not reach the transmission rotation speed. Specifically, the CPU 110 limits the output of the engine 45 by reducing the fuel injection amount according to the engine rotation speed and retarding the ignition time (regarding control) so that the engine rotation speed does not increase even if the throttle opening degree increases. Accordingly, the engine rotation speed does not reach the transmission rotation speed, so that the centrifugal clutch 47 is kept in a disconnected state, and the driving force of the engine 45 is not transmitted to the rear wheel 4. Therefore, the motorcycle 1 is prevented from unintentionally starting traveling in a state where a driver does not get on it.

In the traveling start prohibiting state, in response to a predetermined engine stop trigger operation performed by a driver (Step S37), the CPU 110 stops the engine 45 (Step S38). For example, when the accelerator opening degree reaches a predetermined value or more, this is detected by the throttle opening degree sensor 95, and in response to this detection, the CPU 110 stops the engine 45 by stopping fuel supply to the engine 45. Therefore, when a driver does not sit on the seat 7, if the engine is restarted unintentionally, by increasing the accelerator opening degree, the engine 45 can be stopped immediately without shutting-off the main switch 40.

As described above, according to the present preferred embodiment, when the starter motor 43 is actuated, the ignition coil energization time corresponding to the angular velocity of the crankshaft 48 is measured before starting of the engine 45 is completed. The more the battery 25 deteriorates and the higher the cranking load, the smaller the angular velocity of the crankshaft 48. Specifically, if the angular velocity of the crankshaft 48 when the engine starts is small, there is a possibility that a battery output necessary for starting the engine 45 by sufficiently rotating the crankshaft 48 against the cranking load has not been secured. If the angular velocity of the crankshaft 48 when the engine starts is sufficiently large, it is considered that a battery output sufficient for starting the engine has been secured even if the battery voltage slightly decreases. Therefore, in the present preferred embodiment, when the angular velocity of the crankshaft 48 at the time of start is a predetermined value or less, that is, when the ignition coil energization time is a predetermined threshold or more, it is judged that the battery 25 has deteriorated. Accordingly, unlike the case where the battery voltage is compared with a predetermined threshold, deterioration of the battery 25 can be properly judged from the point of view of whether starting of the engine 45 is possible in consideration of the magnitude of the cranking load.

In addition, in the present preferred embodiment, based on either one detected earlier of the second detection body S and the tooth-missing position N, a reference position is set, and based on the reference position thus set, the energization start detection body P6 and the ignition detection body P7 are identified. Therefore, after the starter motor 43 is started, the energization start detection body P6 can be quickly identified, that is, identified before the crankshaft 48 has rotated 360 degrees. Therefore, after the starter motor 43 is started, while the angular velocity of the crankshaft 48 is low, the ignition coil energization time can be measured. Therefore, deterioration of the battery 25 can be properly judged.

In addition, the energization start detection body P6 is disposed just before the top dead point position, so that the ignition coil energization time as an angular velocity-equivalent value just before the top dead point position at which the cranking load increases can be measured. Accordingly, deterioration of the battery 25 can be more properly judged.

Further, in the present preferred embodiment, an ignition coil energization time is measured from a timing at which the energization start detection body P6 is identified for the first time. Accordingly, an ignition coil energization time as an angular velocity-equivalent value just before the compression top dead point at which the cranking load becomes maximum can be measured. The reason for this is that the cranking load becomes maximum just before the compression top dead point position, so that if the engine 45 is stopped, at a high degree of probability, the crankshaft 48 stops at a rotation position before the compression top dead point. Specifically, the first top dead point position after the engine starts is the compression top dead point position in most cases. Therefore, by measuring an ignition coil energization time in response to first identification of the energization start detection body P6 after the engine starts, at a high degree of probability, the measured value corresponds to the angular velocity of the crankshaft just before the compression top dead point position. By evaluating the angular velocity of the crankshaft 48 just before the compression top dead point position, it can be more properly judged whether the battery 25 starts the engine 45 while having enough power.

In the present preferred embodiment, the second detection body S is disposed between the energization start detection body P6 and the detection body P5 that passes through the detection region 96a of the crank angle sensor 96 just before the energization start detection body P6. Therefore, the possibility that the energization of the ignition coil 79 can be started when the energization start detection body P6 passes through the detection region 96a of the crank angle sensor 96 for the first time after the starter motor 43 is started increases. Accordingly, after the starter motor 43 is started, before the angular velocity of the crankshaft 48 increases, an energization time of the ignition coil 79 can be measured, so that based on the measured energization time, judgment on deterioration of the battery 25 can be more properly made.

Further, according to the present preferred embodiment, a deterioration state of the battery 25 is properly judged based on information equivalent to the angular velocity of the crankshaft 48 when cranking, and based on the properly judged battery deterioration state, it is judged whether the engine 45 should be switched into an idling-stop state. Therefore, when the battery 25 deteriorates, the engine 45 is not switched into an idling-stop state. In other words, when the engine 45 is switched into an idling-stop state, the battery 25 has not deteriorated. Therefore, when restart conditions are satisfied in an idling-stop state, the engine 45 can be reliably restarted. When the output of the battery 25 is sufficient against the cranking load, the engine 45 can be switched into an idling-stop state, so that the battery 25 is prevented from being wastefully depleted. Accordingly, energy-saving performance can be improved.

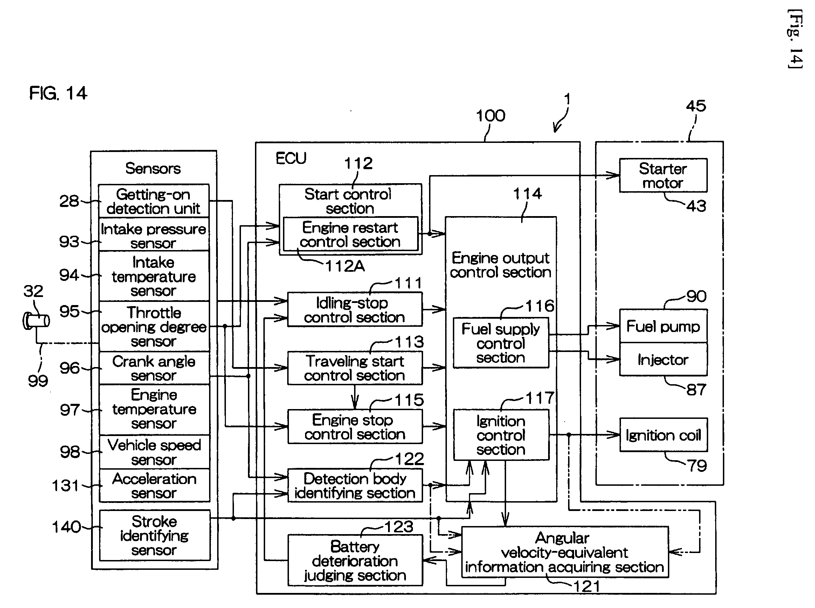

Fig. 14 is a block diagram for describing a configuration of an engine control device according to another preferred embodiment of the present invention. In Fig. 14, portions corresponding to the components shown in Fig. 7 described above are provided with the same reference symbols. Fig. 1 to Fig. 6, Fig. 8 to Fig. 10, Fig. 12, and Fig. 13 described above are also referred to.

In the present preferred embodiment, the rotor 75 coupled to the crankshaft 48 has only first detection bodies P1 to P11, and does not have the second detection body S. Further, in the present preferred embodiment, a stroke identification sensor 140 that identifies strokes of the engine 45 is provided, and an output signal of the stroke identification sensor 140 is input into the ECU 100.

The stroke identification sensor 140 is a sensor for identifying strokes (intake stroke, compression stroke, expansion stroke, and exhaust stroke) of the four-stroke engine 45. One cycle of the four-stroke engine 45 is equivalent to two rotations (720 degrees) of the crankshaft 48. Therefore, the stroke cannot be identified only from the angle position of the crankshaft 48. For example, the stroke identification sensor 140 generates a stroke identification pulse at a timing just before start of the energization of the ignition coil 79 in a compression stroke. The stroke identification sensor 140 generates a stroke identification pulse at a timing just before the compression top dead point position, and does not generate a stroke identification pulse at a timing just before the exhaust top dead point.

The detection body identifying section 122 identifies the first detection bodies P1 to P11 based on the tooth-missing position N, and identifies the first detection bodies P1 to P11 by using an output signal of the stroke identification sensor 140 as well. The ignition control section 117 uses an output signal of the stroke identification sensor 140 in addition to the results of detection body identification performed by the detection body identifying section 122. Specifically, the ignition control section 117 energizes the ignition coil 79 at a timing at which the energization start detection body P6 is detected in a compression stroke, and in an exhaust stroke, does not energize the ignition coil 79 even if the energization start detection body P6 is detected.

The angular velocity-equivalent information acquiring section 121 preferably measures a time during which an energization command for the ignition coil 79 is issued or a time during which an electric current is supplied to the ignition coil 79. Alternatively, the angular velocity-equivalent information acquiring section 121 may measure a time interval from a crank pulse corresponding to the energization start detection body P6 to a crank pulse corresponding to the ignition detection body P7 in a compression stroke by using an output signal of the stroke identification sensor 140.

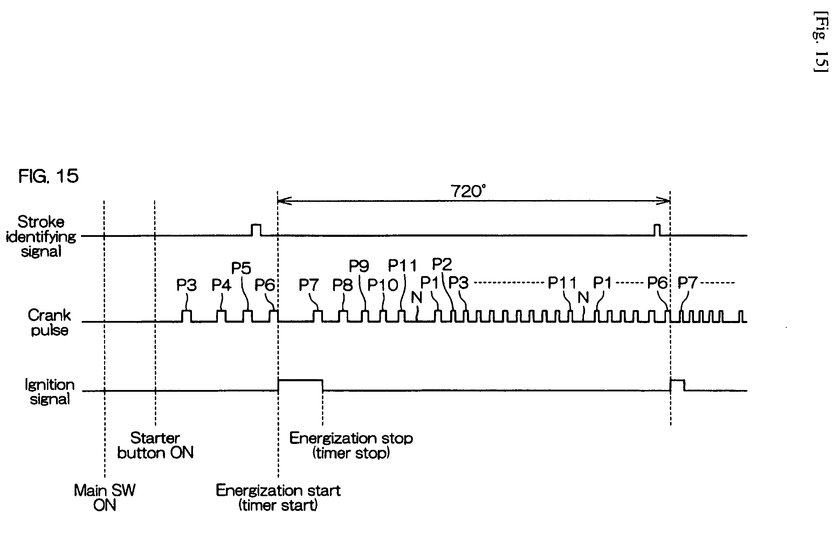

Fig. 15 is a waveform chart showing waveform examples of a stroke identification signal, crank pulses, and an ignition signal when the engine 45 starts. The engine 45 stops when the crankshaft 48 is at a position before the compression top dead point position in many cases. The reason for this is that the cranking load becomes maximum at the compression top dead point position as described above. Therefore, immediately after the engine 45 is started, a stroke identification pulse is generated from the stroke identification sensor 140, and subsequently, a crank pulse corresponding to the energization start detection body P6 is generated. Therefore, by using an output of the stroke identification sensor 140, the detection body identifying section 122 can identify the energization start detection body P6 without waiting for the tooth-missing position N. Therefore, the ignition control section 117 can quickly start ignition control when the starter motor 43 is actuated. The angular velocity-equivalent information acquiring section 121 can start acquisition of angular velocity-equivalent information at a timing at which the energization start detection body P6 passes through the detection region 96a of the crank angle sensor 96 for the first time.

Thus, in the present preferred embodiment, the same operation and effect as those of the first preferred embodiment described above are also obtained. In addition, spark discharge on the ignition plug 80 can be reliably caused in a compression stroke. Moreover, information equivalent to the angular velocity of the crankshaft 48 when cranking before the compression top dead point can be reliably acquired, so that battery deterioration judgment can be performed accurately.

Preferred embodiments of the present invention are described above; however, the present invention can also be carried out in other modes. For example, the above-described preferred embodiment shows an example in which the first detection bodies P1 to P11 and the second detection body S are formed of projections provided on the outer peripheral surface 75a of the rotor 75. However, these detection bodies may be recess portions formed on the outer peripheral surface 75a, or magnetic bodies embedded in the outer peripheral surface 75a. Similarly, in the above-described preferred embodiment, the first reference position detection portion is defined by the tooth-missing position N; however, it is also possible that the first reference position detection portion may be formed of a projection, a recess portion, or a magnetic body. Further, the above-described embodiment shows an example in which the rear ends of the first detection bodies P1 to P11 are disposed at even intervals; however, it is also possible that the front ends of the first detection bodies P1 to P11 are disposed at even intervals, and the front ends of the detection bodies P1 to P11 and S are used as detection edges. However, the output signal of the crank angle sensor 96 is more stable in the case where the rear end positioned on the upstream side in the rotation direction R1 is used as a detection edge, and accordingly, stable detection is realized.

Further, in the above-described preferred embodiments, a configuration in which the power transmission path between the engine 45 and the drive wheel (rear wheel 4) is connected/disconnected by the centrifugal clutch 47 is shown; however, the clutch that connects/disconnects the power transmission path may be realized by other modes such as a hydraulic clutch or an electromagnetic clutch. By controlling the hydraulic clutch or the electromagnetic clutch, etc., according to an engine rotation speed, etc., the same operation as in the case where the centrifugal clutch 47 is used can be realized.

In the above-described preferred embodiment, the configuration in which the throttle valve 92 is mechanically interlocked with the accelerator grip 32 by the wire 99 is described; however, instead of this configuration, a so-called electronic throttle device may be applied. Specifically, while the throttle valve 92 is driven by a throttle actuator such as an electric motor, an accelerator opening degree sensor that detects the operation amount of the accelerator grip 32 (accelerator opening degree) may be provided. In this case, an output signal of the accelerator opening degree sensor is input into the ECU 100. The ECU 100 drives the throttle actuator and adjusts the throttle opening degree according to the output signal of the accelerator opening degree sensor. In this configuration, control in which the throttle opening degree does not depend on the accelerator opening degree can also be performed. Specifically, for example, even when the accelerator opening degree is not changed, the throttle opening degree can be changed. Therefore, for example, even if an increase in accelerator opening degree is detected in a traveling start prohibiting state (refer to Step S36 in Fig. 13), the throttle opening degree is not increased, and the engine rotation speed can be prevented from increasing. Specifically, in the traveling start prohibiting state, even if the accelerator grip 32 is operated, the engine output control section 114 does not actuate the throttle actuator, and keeps the throttle opening degree at a full closing degree (or equal to or less than a value at which the engine rotation speed does not reach the transmission rotation speed). Thus, by adjusting the intake air amount to be taken into the engine 45, the driving force of the engine 45 can be prevented from being transmitted to the rear wheel 4 (refer to Fig. 1). Further, the engine restart control section 112A may perform engine restart control based on an output of the accelerator opening degree sensor (Step S31 in Fig. 13). The engine stop control section 115 may judge whether a predetermined engine stop trigger operation has been performed based on an output signal not of the throttle opening degree sensor 95 but of the output signal of the accelerator opening degree sensor (Step S37 in Fig. 13).

In the above-described preferred embodiment, a scooter type motorcycle 1 is described by way of example; however, the present invention is also applicable to other motorcycles such as a moped type, a sport type, etc. Further, not only to motorcycles, the present invention is also applicable to other saddle type vehicles such as all-terrain vehicles and snowmobiles. Further, the present invention is also applicable not only to engines for saddle type vehicles but also to engines for other types of vehicles and engines to be used for a purpose other than vehicles, such as power generators.

The present application corresponds to Japanese Patent Application No. 2012-153927 filed in the Japan Patent Office on July 9, 2012, and the entire disclosure of the application is incorporated herein by reference.

While preferred embodiments of the present invention have been described above, it is to be understood that variations and modifications will be apparent to those skilled in the art without departing the scope of the present invention. The scope of the present invention, therefore, is to be determined solely by the following claims.

### Reference Signs List

1 Motorcycle
8 Power unit
25 Battery
43 Starter motor
44 Power generator
45 Engine
48 Crankshaft
R1 Rotation direction
49 Crankcase
53 Cylinder
54 Piston
58 Rotor
59 Stator coil
75 Rotor (for crank angle detection)
75a Outer peripheral surface
P1 to P11 First detection body
S Second detection body
N Tooth-missing position
77 Relay
78 Regulator
79 Ignition coil
80 Ignition plug
87 Injector
92 Throttle valve
95 Throttle opening degree sensor
96 Crank angle sensor
96a Detection region
100 ECU
101 Drive control section
103 Ignition coil driving circuit
104 Injector driving circuit
106 One-side edge detection circuit
110 CPU
111 Idling-stop control section
112 Start control section
112A Engine restart control section
113 Traveling start control section
114 Engine output control section
115 Engine stop control section
116 Fuel supply control section
117 Ignition control section
121 Angular velocity-equivalent information acquiring section
122 Detection body identifying section
123 Battery deterioration judging section
140 Stroke identifying sensor

## Claims

1. An engine control device that controls an engine including a starter motor to be driven by electric power supplied from a battery and a crankshaft, the engine control device comprising:
an angular velocity-equivalent information acquiring means that acquires information equivalent to an angular velocity of the crankshaft before starting of the engine is completed when starting the engine by actuating the starter motor; and
a battery deterioration judging means that judges that the battery has deteriorated when information acquired by the angular velocity-equivalent information acquiring means is equivalent to an angular velocity of a predetermined value or less;
**characterized in that**
the engine includes an ignition plug that causes spark discharge inside a combustion chamber and an ignition coil that stores energy to be supplied to the ignition plug,
the engine control device includes an ignition control section that energizes the ignition coil when the rotation position of the crankshaft reaches an energization start position,
and stops energization of the ignition coil and makes the ignition plug cause spark discharge when the rotation position of the crankshaft reaches an ignition position, and
the angular velocity-equivalent information acquiring means measures an energization time of the ignition coil.

2. The engine control device according to claim 1, wherein the angular velocity-equivalent information acquiring means acquires information equivalent to an angular velocity of the crankshaft when the rotation position of the crankshaft is just before a compression top dead point position.

3. The engine control device according to claim 1 or 2, further comprising:
a rotary member that rotates together with the crankshaft, and has a plurality of detection bodies disposed at even intervals along a rotation direction of the crankshaft;
a detection means that has a detection region at a fixed position on a path that the detection bodies pass through according to rotation of the rotary member, and detects passages of the detection bodies through the detection region; and
a detection body identifying means that identifies an energization start detection body that provides a timing to start energization of the ignition coil and an ignition detection body that provides a timing of ignition of the ignition plug among the plurality of detection bodies based on an output of the detection means, wherein
the ignition control section starts energization of the ignition coil in response to identification of the energization start detection body, and
stops energization of the ignition coil in response to identification of the ignition detection body.

4. The engine control device according to claim 3, wherein the angular velocity-equivalent information acquiring means measures an energization time of the ignition coil by measuring a time from identification of the energization start detection body to identification of the ignition detection body, a time during which the ignition control section issues an energization command, or a time during which an electric current is supplied to the ignition coil.

5. The engine control device according to claim 3 or 4, further comprising: a stroke identifying means that identifies a stroke of the engine, wherein the angular velocity-equivalent information acquiring means measures the energization time of the ignition coil in a compression stroke based on results of stroke identification performed by the stroke identifying means.

6. The engine control device according to any one of claims 3 to 5, wherein
the rotary member includes a first reference position detection portion that provides a first reference rotation position of the crankshaft, and a second reference position detection portion that provides a second reference rotation position different from the first reference rotation position,
the first reference position detection portion and the second reference position detection portion are provided on the rotary member so as to pass through the detection region of the detection means, and are configured to be distinguished from each other based on an output of the detection means, and
the detection body identifying means identifies the energization start detection body and the ignition detection body by using, as a reference, either one detected earlier of the first reference position detection portion and the second reference position detection portion after driving of the starter motor is started.

7. The engine control device according to claim 6, wherein the second reference position detection portion is disposed between the energization start detection body and the detection body that is detected just before the energization start detection body by the detection means.

8. The engine control device according to any one of claims 1 to 7, further comprising:
an idling-stop control section that switches the engine into an idling stop state when a predetermined idling-stop condition is satisfied during an idling state of the engine, and
an engine restart control section that restarts the engine when a predetermined restart condition is satisfied during the idling-stop state, wherein
the idling-stop condition includes a condition that the battery deterioration judging means does not judge that the battery has deteriorated.

9. A vehicle comprising: the engine control device set forth in any one of claims 1 to 8; and an engine to be controlled by the engine control device, wherein the engine is used as a power source of the vehicle.

## Patentansprüche

1. Eine Motorsteuervorrichtung, die einen Motor steuert, der einen Anlasser beinhaltet, der durch elektrische Leistung, die von einer Batterie geliefert wird, angetrieben werden soll, sowie eine Kurbelwelle, wobei die Motorsteuervorrichtung folgende Merkmale aufweist:
eine Winkelgeschwindigkeitsäquivalenz-Informationserfassungseinrichtung, die Informationen erfasst, die äquivalent zu einer Winkelgeschwindigkeit der Kurbelwelle sind, bevor ein Starten des Motors abgeschlossen ist, wenn der Motor durch Betätigen des Anlassers gestartet wird; und
eine Batterierückgangbeurteilungseinrichtung, die beurteilt, dass die Batterie zurückgegangen ist, wenn Informationen, die durch die Winkelgeschwindigkeitsäquivalenz-Informationserfassungseinrichtung erfasst werden, äquivalent zu einer Winkelgeschwindigkeit mit einem vorbestimmten Wert oder weniger sind;
**dadurch gekennzeichnet, dass**:
der Motor eine Zündkerze, die eine Funkenentladung innerhalb einer Verbrennungskammer bewirkt, und eine Zündspule aufweist, die Energie speichert, die an die Zündkerze geliefert werden soll, wobei die Motorsteuervorrichtung einen Zündsteuerabschnitt aufweist, der die Zündspule mit Energie versorgt, wenn die Drehposition der Kurbelwelle eine Energieversorgungsstartposition erreicht, und eine Energieversorgung der Zündspule stoppt und bewirkt, dass die Zündkerze eine Funkenentladung vollzieht, wenn die Drehposition der Kurbelwelle eine Zündposition erreicht, und die Winkelgeschwindigkeitsäquivalenz-Informationserfassungseinrichtung eine Energieversorgungszeit der Zündspule misst.

2. Die Motorsteuervorrichtung gemäß Anspruch 1, bei der die Winkelgeschwindigkeitsäquivalenz-Informationserfassungseinrichtung Informationen erfasst, die äquivalent zu einer Winkelgeschwindigkeit der Kurbelwelle sind, wenn die Drehposition der Kurbelwelle kurz vor einer oberen Kompressionstotpunktposition ist.

3. Die Motorsteuervorrichtung gemäß Anspruch 1 oder 2, die ferner folgende Merkmale aufweist:
ein Drehbauteil, das sich zusammen mit der Kurbelwelle dreht und eine Mehrzahl von Detektionskörpern aufweist, die in gleichmäßigen Abständen entlang einer Drehrichtung der Kurbelwelle angeordnet sind;
eine Detektionseinrichtung, die eine Detektionsregion an einer fixen Position auf einem Weg aufweist, den die Detektionskörper gemäß einer Drehung des Drehbauteils durchlaufen, und Durchgänge der Detektionskörper durch die Detektionsregion detektiert; und
eine Detektionskörperidentifizierungseinrichtung, die einen Energieversorgungsstart-Detektionskörper, der eine Zeitgebung zum Beginn einer Energieversorgung der Zündspule bereitstellt, und einen Zünddetektionskörper, der eine Zeitgebung für eine Zündung der Zündkerze bereitstellt, unter der Mehrzahl von Detektionskörpern, basierend auf einer Ausgabe der Detektionseinrichtung identifiziert, wobei:
der Zündsteuerabschnitt eine Energieversorgung der Zündspule ansprechend auf eine Identifizierung des Energieversorgungsstart-Detektionskörpers startet, und
eine Energieversorgung der Zündspule ansprechend auf eine Identifizierung des Zünddetektionskörpers stoppt.

4. Die Motorsteuervorrichtung gemäß Anspruch 3, bei der die Winkelgeschwindigkeitsäquivalenz-Informationserfassungseinrichtung eine Energieversorgungszeit der Zündspule durch Messen einer Zeit von einer Identifizierung des Energieversorgungsstart-Detektionskörpers bis zu einer Identifizierung des Zünddetektionskörpers, oder einer Zeit, während der der Zündsteuerabschnitt einen Energieversorgungsbefehl ausgibt, oder einer Zeit misst, während der ein elektrischer Strom an die Zündspule geliefert wird.

5. Die Motorsteuervorrichtung gemäß Anspruch 3 oder 4, die ferner folgendes Merkmal aufweist: eine Taktidentifizierungseinrichtung, die einen Takt des Motors identifiziert, wobei die Winkelgeschwindigkeitsäquivalenz-Informationserfassungseinrichtung die Energieversorgungszeit der Zündspule in einem Kompressionstakt basierend auf Ergebnissen einer Taktidentifizierung misst, die durch die Taktidentifizierungseinrichtung durchgeführt wird.

6. Die Motorsteuervorrichtung gemäß einem der Ansprüche 3 bis 5, bei der:
das Drehbauteil einen ersten Referenzpositionsdetektionsteil, der eine erste Referenzdrehposition der Kurbelwelle bereitstellt, und einen zweiten Referenzpositionsdetektionsteil aufweist, der eine zweite Referenzdrehposition, die sich von der ersten Referenzdrehposition unterscheidet, bereitstellt,
der erste Referenzpositionsdetektionsteil und der zweite Referenzpositionsdetektionsteil so an dem Drehbauteil vorgesehen sind, dass sie die Detektionsregion der Detektionseinrichtung durchlaufen, und ausgebildet sind, um voneinander basierend auf einer Ausgabe der Detektionseinrichtung unterschieden zu werden, und
die Detektionskörperidentifizierungseinrichtung den EnergieversorgungsstartDetektionskörper und den Zünddetektionskörper unter Verwendung desjenigen des ersten Referenzpositionsdetektionsteils und des zweiten Referenzpositionsdetektionsteils, der früher detektiert wird, als Referenz, nachdem ein Antreiben des Anlassers gestartet wird, identifiziert.

7. Die Motorsteuervorrichtung gemäß Anspruch 6, bei der der zweite Referenzpositionsdetektionsteil zwischen dem Energieversorgungsstart-Detektionskörper und dem Detektionskörper angeordnet ist, der kurz vor dem EnergieversorgungsstartDetektionskörper durch die Detektionseinrichtung detektiert wird.

8. Die Motorsteuervorrichtung gemäß einem der Ansprüche 1 bis 7, die ferner folgendes Merkmal aufweist:
einen Leerlaufstopp-Steuerabschnitt, der den Motor in einen Leerlaufstopp-Zustand schaltet, wenn eine vorbestimmte Leerlaufstopp-Bedingung während eines Leerlaufzustands des Motors erfüllt ist, und
einen Motorneustart-Steuerabschnitt, der den Motor neustartet, wenn eine vorbestimmte Neustartbedingung während des Leerlaufstopp-Zustands erfüllt ist, wobei
die Leerlaufstopp-Bedingung eine Bedingung aufweist, dass die Batterierückgangbeurteilungseinrichtung nicht beurteilt, dass die Batterie zurückgegangen ist.

9. Ein Fahrzeug mit: der Motorsteuervorrichtung gemäß einem der Ansprüche 1 bis 8; und einem Motor, der durch die Motorsteuervorrichtung gesteuert werden soll, wobei der Motor als eine Leistungsquelle des Fahrzeugs verwendet wird.

## Revendications

1. Dispositif de commande de moteur qui commande un moteur comportant un démarreur de moteur destiné à être entraîné par l'énergie électrique alimentée par une batterie et un vilebrequin, le dispositif de commande de moteur comprenant:
un moyen d'acquisition d'informations équivalentes à la vitesse angulaire qui acquiert des informations équivalentes à une vitesse angulaire du vilebrequin avant que ne se termine le démarrage du moteur lors du démarrage du moteur en actionnant le démarreur de moteur; et
un moyen de jugement de détérioration de batterie qui juge que la batterie est détériorée lorsque les informations acquises par le moyen d'acquisition d'informations équivalentes à la vitesse angulaire sont équivalentes à une vitesse angulaire d'une valeur prédéterminée ou inférieure;
**caractérisé par le fait que**
le moteur comporte une bougie d'allumage qui provoque une décharge d'étincelles dans une chambre de combustion et une bobine d'allumage qui accumule l'énergie à alimenter vers la bougie d'allumage,
le dispositif de commande de moteur comporte un segment de commande d'allumage qui excite la bobine d'allumage lorsque la position de rotation du vilebrequin atteint une position de début d'excitation, et arrête l'excitation de la bobine d'allumage et fait que la bougie d'allumage provoque la décharge d'étincelles lorsque la position de rotation du vilebrequin atteint une position d'allumage et le moyen d'acquisition d'informations équivalentes à. la vitesse angulaire mesure un temps d'excitation de la bobine d'allumage.

2. Dispositif de commande de moteur selon la revendication 1, dans lequel le moyen d'acquisition d'informations équivalentes à la vitesse angulaire acquiert des informations équivalentes à une vitesse angulaire du vilebrequin lorsque la position de rotation du vilebrequin est immédiatement avant une position de point mort haut de compression.

3. Dispositif de commande de moteur selon la revendication 1 ou 2, comprenant par ailleurs:
un élément rotatif qui tourne ensemble avec le vilebrequin, et présente une pluralité de corps de détection disposés à intervalles réguliers dans une direction de rotation du vilebrequin;
un moyen de détection qui présente une région de détection à une position fixe sur un trajet par lequel passent les corps de détection selon la rotation de l'élément rotatif, et détecte les passages des corps de détection par la région de détection, et
un moyen d'identification de corps de détection qui identifie un corps de détection de début d'excitation qui prévoit un moment pour démarrer l'excitation de la bobine d'allumage et un corps de détection d'allumage qui prévoit un moment d'allumage de la bougie d'allumage parmi la pluralité de corps de détection sur base d'une sortie du moyen de détection, dans lequel le segment de commande d'allumage commence l'excitation de la bobine d'allumage en réponse à l'identification du corps de détection de début d'excitation, et
arrête l'excitation de la bobine d'allumage en réponse à l'identification du corps de détection d'allumage.

4. Dispositif de commande de moteur selon la revendication 3, dans lequel le moyen d'acquisition d'informations équivalentes à la vitesse angulaire mesure un temps d'excitation de la bobine d'allumage en mesurant un laps de temps de l'identification du corps de détection de début d'excitation à l'identification du corps de détection d'allumage, un laps de temps pendant lequel le segment de commande d'allumage émet une commande d'excitation ou un laps de temps pendant lequel un courant électrique est alimenté vers la bobine d'allumage.

5. Dispositif de commande de moteur selon la revendication 3 ou 4, comprenant par ailleurs: un moyen d'identification de course qui identifie une course du moteur, dans lequel le moyen d'acquisition d'informations équivalentes à la vitesse angulaire mesure le temps d'excitation de la bobine d'allumage lors d'une course de compression sur base des résultats de l'identification de course réalisée par le moyen d'identification de course.

6. Dispositif de commande de moteur selon l'une quelconque des revendications 3 à 5, dans lequel
l'élément rotatif comporte une première partie de détection de position de référence qui fournit une première position de rotation de référence du vilebrequin et une deuxième partie de détection de position de rotation de référence qui fournit une deuxième position de rotation de référence différente de la première position de rotation de référence,
la première partie de détection de position de référence et la deuxième partie de détection de position de référence sont prévues sur l'élément rotatif de manière à passer par la région de détection du moyen de détection, et sont configurés de manière à être distinguées l'une de l'autre sur base d'une sortie du moyen de détection, et
le moyen d'identification de corps de détection identifie le corps de détection de début d'excitation et le corps de détection d'allumage à l'aide, comme référence, de l'une ou l'autre détectée en premier lieu parmi la première partie de détection de position de référence et de la deuxième partie de détection de position de référence après que soit démarré l'entraînement du démarreur de moteur.

7. Dispositif de commande de moteur selon la revendication 6, dans lequel la deuxième partie de détection de position de référence est disposée entre le corps de détection de début d'excitation et le corps de détection qui est détecté immédiatement avant le corps de détection de début d'excitation par le moyen de détection.

8. Dispositif de commande de moteur selon l'une quelconque des revendications 1 à 7, comprenant par ailleurs:
un segment de commande de ralenti-arrêt qui commute le moteur à un état de ralenti-arrêt quand une condition de ralenti-arrête prédéterminée est remplie pendant un état de ralenti du moteur, et un segment de commande de redémarrage du moteur qui redémarre le moteur quand une condition de redémarrage prédéterminée est remplie pendant l'état de ralenti-arrêt, dans lequel
la condition de ralenti-arrêt comporte la condition que le moyen de jugement de détérioration de batterie ne juge pas que la batterie est détériorée.

9. Véhicule comprenant: le dispositif de commande de moteur selon l'une quelconque des revendications 1 à 8; et un moteur à commander par le dispositif de commande du moteur, dans lequel le moteur est utilisé comme source d'énergie du véhicule.
